# EUROPEAN PATENT APPLICATION

(11) **EP 4 664 532 A1**
(43) Date of publication of application: **17.12.2025**
(21) Application number: 23927936.7
(22) Date of filing: 20.03.2023
(51) Int. Cl.: H01L 33/62

(54) **DISPLAY PANEL, DISPLAY DEVICE, AND TILED DISPLAY DEVICE**

(71) Applicant: BOE Technology Group Co., Ltd., Beijing 100015 (CN); BOE MLED Technology Co., Ltd., Beijing 100176 (CN)
(72) Inventor: JIA, Mingming, Beijing 100176 (CN); WANG, Jing, Beijing 100176 (CN); FENG, Sha, Beijing 100176 (CN); WANG, Lili, Beijing 100176 (CN); HAN, Shiwei, Beijing 100176 (CN); LIU, Chao, Beijing 100176 (CN); ZHAI, Ming, Beijing 100176 (CN)
(74) Representative: Hoffmann Eitle
(86) International application number: PCT/CN2023/082457
(87) International publication number: WO 2024/192619

(57) **Abstract**

A display panel, a display device, and a tiled display device. The display panel comprises a substrate, a plurality of light-emitting devices, a plurality of first electrodes, a plurality of second electrodes, and a plurality of connecting traces. The substrate comprises a first surface and a second surface, and a plurality of side surfaces, which connect the first surface and the second surface, wherein at least one of the plurality of side surfaces is a selected side surface. Each of the plurality of connecting traces comprises a first section, a second section and a third section, which are sequentially connected, wherein the first section is at least arranged on the first surface, and is electrically connected to one of the plurality of first electrodes; the second section is arranged on the selected side surface; the third section is at least arranged on the second surface, and is electrically connected to one of the plurality of second electrodes; and the maximum width of the first section in a first direction and/or the maximum width of the third section in the first direction are/is greater than the maximum width of the second section in the first direction.

## Description

### TECHNICAL FIELD

The present disclosure relates to the field of display technologies, and in particular, to a display panel, a display apparatus and a tiled display apparatus.

### BACKGROUND

Mini light-emitting diode (mini LED) display apparatuses and micro light-emitting diode (micro LED) display apparatuses have self-luminous display characteristics, and advantages including all-solid-state, long service life, high brightness, low power consumption, relatively small size, ultra-high resolution, etc.

Since the mass transfer process of mini LED chips in mini LED display apparatuses and micro LED chips in micro LED display apparatuses is difficult, it is difficult to directly prepare large-size display apparatuses. Therefore, multiple small-sized mini LED display apparatuses or multiple small-sized micro LED display apparatuses are usually tiled together to achieve the preparation of large-sized display panels.

### SUMMARY

In an aspect, a display panel is provided. The display panel includes a substrate, a plurality of light-emitting devices, first electrodes, second electrodes and connecting traces. The substrate includes a first surface, a second surface and a plurality of side surfaces connecting the first surface and the second surface. At least one of the plurality of side surfaces is a selected side surface. The plurality of light-emitting devices are disposed on the first surface. The plurality of first electrodes are disposed on the first surface and arranged at intervals in a first direction. The plurality of first electrodes are closer to the selected side surface than the plurality of light-emitting devices. The plurality of second electrodes are disposed on the second surface, arranged at intervals in the first direction and close to the selected side surface. The plurality of connecting traces are arranged in parallel and at intervals. Each connecting trace of the plurality of connecting traces includes a first portion, a second portion and a third portion that are connected in sequence. The first portion is disposed at least on the first surface, and the first portion is electrically connected to a first electrode of the plurality of first electrodes. The second portion is disposed on the selected side surface. The third portion is disposed at least on the second surface and electrically connected to a second electrode of the plurality of second electrodes. A maximum width of the first portion in the first direction and/or a maximum width of the third portion in the first direction is greater than a maximum width of the second portion in the first direction.

In some embodiments, for at least one connecting trace, in at least two line segments, in the first direction, of an orthographic projection pattern of a first portion on the first surface, a dimension of a line segment proximate to the selected side surface in the first direction is greater than a dimension of another line segment away from the selected side surface in the first direction; and/or, in at least two line segments, in the first direction, of an orthographic projection pattern of a third portion on the second surface, a dimension of a line segment proximate to the selected side surface in the first direction is greater than a dimension of another line segment away from the selected side surface in the first direction.

In some embodiments, the second portion of the connecting trace includes a first end and a second end, and a dimension of the first end in the first direction is greater than a dimension of the second end in the first direction.

In some embodiments, the first portion partially overlaps with the first electrode, and the third portion partially overlaps with the second electrode.

In some embodiments, the display panel further includes a plurality of signal lines disposed on the first surface; the plurality of signal lines electrically connect the plurality of first electrodes and the plurality of light-emitting devices; each signal line is electrically connected to a first electrode, and a dimension of the signal line in the first direction is not greater than a dimension of the first electrode in the first direction.

In some embodiments, the display panel further includes at least one extension line disposed on a side of at least one first electrode proximate to the selected side surface; the at least one extension line is electrically connected to a first electrode, and the at least one extension line is electrically connected to a connecting trace.

In some embodiments, a number of extension lines electrically connected to the first electrode is multiple, and a spacing between any two extension lines is greater than or equal to 60 µm.

In some embodiments, at least two extension lines are electrically connected to a first portion of the connecting trace; a dimension of the first portion in the first direction is greater than a spacing between two extension lines; or, the first portion includes at least two sub-portions, a dimension of any sub-portion in the first direction is not less than a dimension of any extension line in the first direction, and the at least two sub-portions respectively overlap with the at least two extension lines.

In some embodiments, a dimension of an extension line in the first direction is less than or equal to 30 µm.

In some embodiments, the plurality of signal lines and the extension line are formed by a first metal layer, the plurality of first electrodes are formed by the first metal layer and a second metal layer, and the second metal layer is further away from the first surface than the first metal layer.

In some embodiments, for a signal line and an extension line that are connected to each other, a dimension of the signal line in the first direction is greater than a dimension of the extension line in the first direction.

In some embodiments, the substrate includes a first substrate and a second substrate; the first substrate includes: the first surface and a third surface that are opposite to each other, and a plurality of first side surfaces connecting the first surface and the second surface; the second substrate includes: a fourth surface and the second surface that are opposite to each other, and a plurality of second side surfaces connecting the fourth surface and the second surface; the third surface and the fourth surface are close to each other; at least one first side surface of the plurality of first side surfaces is a first selected side surface, at least one second side surface of the plurality of second side surfaces is a second selected side surface, and the first selected side surface and the second selected side surface are located in a same plane to constitute the selected side surface of the substrate.

In some embodiments, the second surface includes a first region and a second region, the first region and the first surface have a first distance therebetween, and the second region and the first surface have a second distance therebetween, and the first distance is greater than the second distance.

In some embodiments, the first distance is twice the second distance.

In some embodiments, the substrate further includes an adhesive layer; the adhesive layer is disposed between the third surface and the fourth surface and configured to bond the third surface and the fourth surface together.

In some embodiments, a material of the adhesive layer is a thermal curing or ultraviolet (UV) curing material, and a plurality of silicone balls are evenly provided in the adhesive layer.

In another aspect, a display apparatus is provided. The display apparatus includes the display panel as mentioned in any one of the above embodiments and a driving circuit board. The driving circuit board is disposed on the second surface of the substrate of the display panel. The driving circuit board is electrically connected to the plurality of connecting traces of the display panel.

In yet another aspect, a tiled display apparatus is provided. The tiled display apparatus includes display apparatuses as mentioned is any one of the above embodiments, and the selected side surfaces of display apparatuses located in a same row or a same column are located on a same side.

### BRIEF DESCRIPTION OF THE DRAWINGS

In order to describe technical solutions in the present disclosure more clearly, the accompanying drawings to be used in some embodiments of the present disclosure will be briefly introduced below. Obviously, the accompanying drawings to be described below are merely drawings of some embodiments of the present disclosure, and a person of ordinary skill in the art can obtain other drawings according to these drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display panel, in accordance with some embodiments.
FIG. 2A is a sectional view of a display panel, in accordance with some embodiments.
FIG. 2B is another sectional view of a display panel, in accordance with some embodiments.
FIG. 3 is yet another sectional view of a display panel, in accordance with some embodiments.
FIG. 4 is a partial real photo of connecting traces of the display panel, in accordance with some embodiments.
FIG. 5A is a structural diagram showing connection between a connecting trace and a first electrode of a display panel, in accordance with some embodiments.
FIG. 5B is another structural diagram showing connection between a connecting trace and a first electrode of a display panel, in accordance with some embodiments.
FIG. 6 is a structural diagram showing connection between a connecting trace and a second electrode of a display panel, in accordance with some embodiments.
FIG. 7A is a structural diagram of a display panel, in accordance with some embodiments.
FIG. 7B is another structural diagram of a display panel, in accordance with some embodiments.
FIG. 7C is a sectional view of a display panel, in accordance with some embodiments.
FIG. 8A is a structural diagram showing connection between a connecting trace and extension lines of a display panel, in accordance with some embodiments.
FIG. 8B is another structural diagram showing connection between a connecting trace and an extension line of a display panel, in accordance with some embodiments.
FIG. 8C is a sectional view of an extension line of a display panel, in accordance with some embodiments.
FIG. 9 is another structural diagram showing connection between a connecting trace and an extension line of a display panel, in accordance with some embodiments.
FIG. 10A is a side structural view of a substrate of a display panel, in accordance with some embodiments.
FIG. 10B is another side structural view of a substrate of a display panel, in accordance with some embodiments.
FIG. 11A is yet another side structural view of a substrate of a display panel, in accordance with some embodiments.
FIG. 11B is yet another side structural view of a substrate of a display panel, in accordance with some embodiments.
FIG. 12A is a structural diagram of an adhesive layer of a display panel, in accordance with some embodiments.
FIG. 12B is another structural diagram of an adhesive layer of a display panel, in accordance with some embodiments.
FIG. 13 is a structural diagram of a display device, in accordance with some embodiments.
FIG. 14 is another structural diagram of a display device, in accordance with some embodiments.
FIG. 15 is a structural diagram of a tiled display device, in accordance with some embodiments.
FIG. 16 is a flow chart of a manufacturing method for a display panel, in accordance with some embodiments.
FIG. 17 is another flow chart of a manufacturing method for a display panel, in accordance with some embodiments.
FIG. 18A is a structural diagram of an initial first substrate of a display panel, in accordance with some embodiments.
FIG. 18B is another structural diagram of an initial first substrate of a display panel, in accordance with some embodiments.
FIG. 18C is a structural diagram of an initial second substrate of a display panel, in accordance with some embodiments.
FIG. 18D is another structural diagram of an initial second substrate of a display panel, in accordance with some embodiments.
FIG. 19A is a flow chart of a manufacturing method for a display panel, in accordance with some embodiments.
FIG. 19B is another flow chart of a manufacturing method for a display panel, in accordance with some embodiments.
FIG. 19C is yet another flow chart of a manufacturing method for a display panel, in accordance with some embodiments.
FIG. 20 is a flow chart of a manufacturing method for a display panel, in accordance with some embodiments.
FIG. 21A is a diagram showing a process of a manufacturing method for a display panel, in accordance with some embodiments.
FIG. 21B is another diagram showing a process of a manufacturing method for a display panel, in accordance with some embodiments.
FIG. 21C is yet another diagram showing a process of a manufacturing method for a display panel, in accordance with some embodiments.
FIG. 22A is a diagram showing a process of a manufacturing method for a display panel, in accordance with some embodiments.
FIG. 22B is another diagram showing a process of a manufacturing method for a display panel, in accordance with some embodiments.
FIG. 23 is a diagram showing a process of a manufacturing method for a display panel, in accordance with some embodiments.

### DETAILED DESCRIPTION

The technical solutions in the embodiments of the present disclosure will be described clearly and completely below with reference to the accompanying drawings. Obviously, the described embodiments are merely some but not all of embodiments of the present disclosure. All other embodiments obtained by a person of ordinary skill in the art based on the embodiments provided by the present disclosure shall fall within the protection scope of the present disclosure.

Unless the context requires otherwise, throughout the detailed description and claims, the term "comprise" and other forms thereof such as the third-person singular form "comprises" and the present participle form "comprising" are construed as an open and inclusive meaning, i.e., "include, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the said specific features, structures, materials, or characteristics described herein may be included in any one or more embodiments or examples in any suitable manner.

Hereinafter, the terms such as "first" and "second" are used for descriptive purposes only, and cannot be construed as indicating or implying the relative importance or implicitly indicating the number of indicated technical features. Thus, a feature defined with "first" or "second" may explicitly or implicitly include one or more features. In the description of the embodiments of the present disclosure, the term "a plurality of" or "the plurality of" means two or more unless otherwise specified.

Some embodiments may be described using the terms "coupled", "connected" and their derivatives. The term "connected" should be understood in a broad sense. For example, "connected" may be a fixed connection, a detachable connection, or a one-piece connection; it may be a direct connection or an indirect connection through an intermediate medium. The term "coupled" indicates, for example, that two or more components are in direct physical or electrical contact. However, the term "coupled" or "communicatively coupled" may also indicate that two or more components are not in direct contact with each other, but still cooperate or interact with each other. The embodiments disclosed herein are not necessarily limited to the content herein.

The phrase "at least one of A, B and C" has the same meaning as the phrase "at least one of A, B or C", both including following combinations of A, B and C: only A, only B, only C, a combination of A and B, a combination of A and C, a combination of B and C, and a combination of A, B and C.

The phrase "A and/or B" includes following three combinations: only A, only B, and a combination of A and B.

The phrase "applicable to" or "configured to" used herein means an open and inclusive expression, which does not exclude devices that are applicable to or configured to perform additional tasks or steps.

The term such as "about", "substantially" or "approximately" as used herein includes a stated value and an average value within an acceptable range of deviation of a particular value, and the acceptable range of deviation is determined by, for example, a person of ordinary skilled in the art, considering measurement in question and errors associated with measurement of a particular quantity (i.e., limitations of a measurement system).

The term such as "parallel", "perpendicular" or "equal" as used herein includes a stated case and a case similar to the stated case within an acceptable range of deviation, and the acceptable range of deviation is determined by, for example, a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; the term "equal" includes absolute equality and approximate equality, and an acceptable range of deviation of the approximate equality may be, for example, that a difference between two equals is less than or equal to 5% of either of the two equals.

It should be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. In the accompanying drawings, thicknesses of layers and sizes of regions (areas) are enlarged for clarity. Variations in shape relative to the accompanying drawings due to, for example, manufacturing technologies and/or tolerances may be envisaged. Therefore, the exemplary embodiments should not be construed as being limited to the shapes of the regions shown herein, but including deviations of shape due to, for example, manufacturing. For example, an etched region shown in a rectangular shape generally has a feature of being curved. Therefore, the regions shown in the accompanying drawings are schematic in nature, and their shapes are not intended to show actual shapes of the regions in a device, and are not intended to limit the scope of the exemplary embodiments.

In order to improve product reliability and reduce transportation and maintenance costs, large-size display devices can be assembled and formed by tiling multiple small-size display devices.

In order to avoid the image display fragmentation caused by tiling, it is necessary to reduce the bezel size of a single small-size display apparatus and reduce the width of the seam. The small-sized display apparatus includes a display panel. For example, the traces located on the display surface of the display panel may be connected to the circuit board provided on the non-display surface of the display panel through connecting traces located on the side surface of a substrate. Thus, in a case where multiple small-sized display apparatuses are tiled to form a larger large-sized display apparatus, the distance between adjacent small-sized display apparatuses may be small, thereby improving the display quality of the large-sized display apparatus formed by tiling multiple small-sized display apparatuses.

At present, mini light-emitting diode (mini LED) and micro light-emitting diode (micro LED) display panels generally use transparent glass or organic glass as the substrate. In the process of manufacturing the display panel, the defects will inevitably occur for the substrate.

In some embodiments, an array layer is formed on the front side of the substrate through an array process. The array layer includes multiple signal lines and multiple electrodes. Light-emitting devices are provided on a side of the array layer away from the substrate. The multiple signal lines are electrically connected to the light-emitting devices. There are multiple connecting traces provided on the side surface of the substrate. An end of the connecting trace is connected to a metal electrode on the front of the substrate, and the other end of the connecting trace extends to the back of the substrate as an electrode on the back to be connected to the circuit board. The circuit board transmits control signals to the multiple light-emitting devices through the connecting traces and the electrodes on the front, so as to control the image display of the display panel.

In some examples, metal electrodes and connecting traces are obtained by laser etching a metal layer. After etching, the etched surface of the metal layer is exposed and prone to collision and corrosion. Considering the connecting traces as an example, a part of the etched surface of the connecting trace is exposed and is not completely isolated from the outside world. The exposed part is prone to collision and corrosion, which leads to poor wiring and affects the normal transmission of signals. As a result, the normal operation of the display panel is affected.

Based on this, some embodiments of the present disclosure provide a display panel, a display apparatus and a tiled display apparatus. The display panel adopts three-dimensional printing to fabricate side traces, which may avoid circuit damage and corrosion to solve the problem of poor wiring. In addition, there is no need to turn the substrate over during the processing, which prevents scratches, dirt and electrostatic discharge problems caused by a case that the substrate is in contact with the equipment, thereby improving product yield and quality.

The display panel, display apparatus and tiled display apparatus provided by the present disclosure are introduced respectively below.

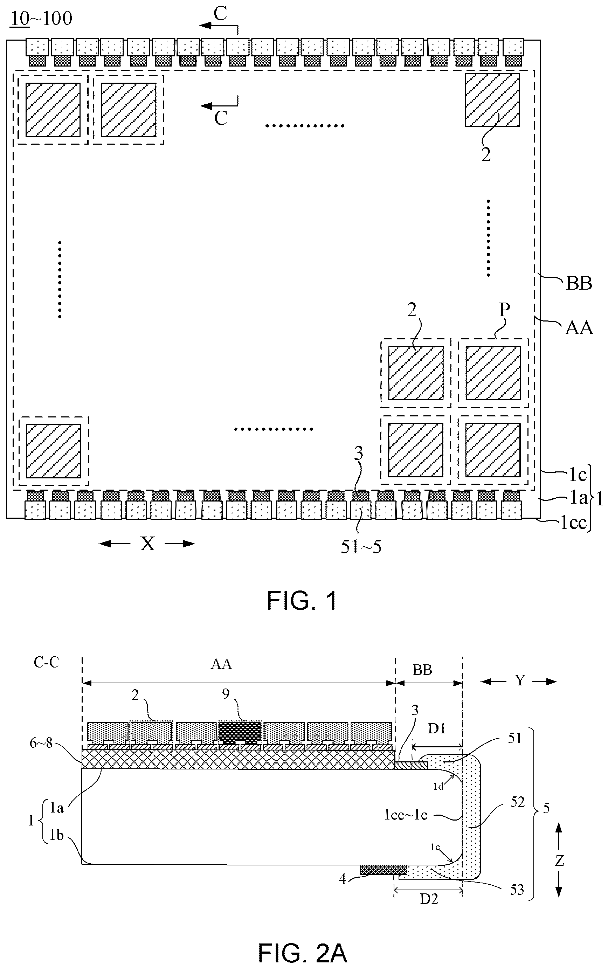

Some embodiments of the present disclosure provide a display panel 10. As shown in FIG. 1, the display panel 10 includes a display area AA and a peripheral area BB disposed at least on one side of the display area AA. For example, the peripheral area BB may be located on one side, two sides or three sides of the display area AA. Alternatively, the peripheral area BB may be arranged around the display area AA.

In some embodiments, as shown in FIG. 2A, the display panel 10 includes a substrate 1, a plurality of light-emitting devices 2, a plurality of first electrodes 3, a plurality of second electrodes 4 and a plurality of connecting traces 5. The substrate 1 includes a first surface 1a and a second surface 1b, and a plurality of side surfaces 1c connecting the first surface 1a and the second surface 1b. The plurality of side surfaces 1c are flat surfaces, and at least one side surface 1c of the plurality of side surfaces 1c of the substrate 1 is a selected side surface 1cc. The plurality of light-emitting devices 2 and the plurality of first electrodes 3 are disposed on the first surface 1a of the substrate. The plurality of first electrodes 3 are arranged at intervals in a first direction X. The plurality of first electrodes 3 are closer to the selected side surface 1cc relative to the plurality of light-emitting devices 2. The plurality of first electrodes 3 are electrically connected to the plurality of light-emitting devices 2. The plurality of second electrodes 4 are disposed on the second surface 1b of the substrate. The plurality of second electrodes 4 are arranged at intervals in the first direction X and close to the selected side surface 1cc.

It should be noted that the plurality of first electrodes 3 and the plurality of light-emitting devices 2 may be in indirect contact with the first surface 1a of the substrate 1. For example, an insulation layer is provided between the plurality of first electrodes 3 and the first surface 1a of the substrate 1, a film layer structure such as a driving circuit layer 8 is provided between the plurality of light-emitting devices 2 and the first surface 1a of the substrate 1, and the driving circuit layer 8 includes a plurality of signal lines. The plurality of first electrodes 3 are electrically connected to the light-emitting devices 2 through the signal lines in the driving circuit layer 8, and the signal lines are configured to transmit signals to the light-emitting devices 2 to drive the light-emitting devices 2 to emit light.

Exemplarily, as shown in FIG. 1, the display panel 10 includes sub-pixels P of at least three colors, and the sub-pixels of multiple colors include at least a sub-pixel of a first color, a sub-pixel of a second color, and a sub-pixel of a third color. The first color, the second color and the third color are the three primary colors (e.g., red, green and blue). Exemplarily, each sub-pixel P includes at least one light-emitting device.

Exemplarily, the light-emitting device 2 includes, but is not limited to, an organic light-emitting diode (OLED), mini LED, micro LED, etc.

The first surface 1a of the substrate 1 is a front surface of the substrate 1, which corresponds to a display side of the display panel 10. The second surface 1b of the substrate 1 is a back surface of the substrate 1, which corresponds to a non-display side of the display panel 10.

Exemplarily, the first surface 1a and the second surface 1b of the substrate 1 are in a shape of, for example, a rectangle, and a material of the substrate 1 is, for example, a rigid material, such as glass, quartz, or plastic.

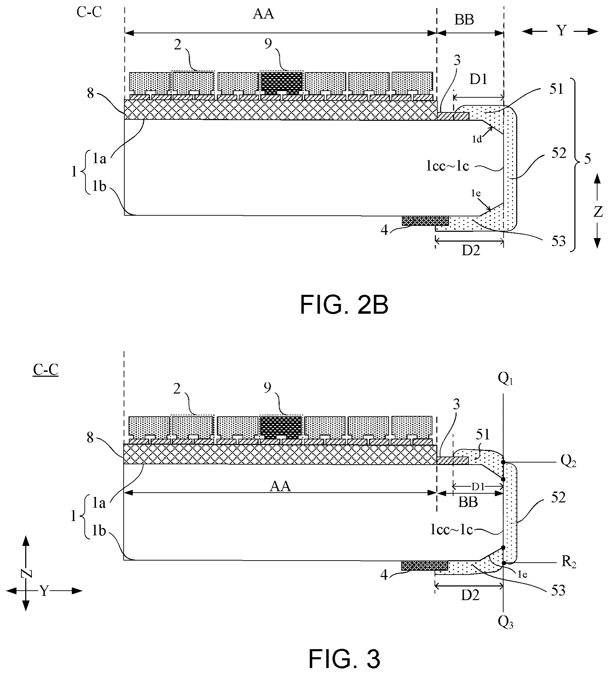

Exemplarily, referring to FIGS. 2A and 2B, the plurality of first electrodes 3 and the plurality of second electrodes 4 extend in a direction, e.g., the second direction Y shown in FIG. 2A, perpendicular to the selected side surface 1cc of the substrate 1. A dimension D1 of each first electrode 3 of the plurality of first electrodes 3 in the second direction Y is less than a dimension D2 of each second electrode 4 of the plurality of second electrodes 4 in the second direction Y. The plurality of first electrode 3 are located in the peripheral area BB of the first surface 1a, and orthographic projections of the plurality of second electrodes 4 on the first surface 1a of the substrate 1 extends to the display area AA.

In some embodiments, the plurality of connecting traces 5 are arranged in parallel and at intervals, and the plurality of connecting traces 5 are formed by three-dimensional printing; referring to FIGS. 2A and 2B, each connecting trace 5 of the plurality of connecting traces 5 includes a first portion 51, a second portion 52 and a third portion 53 that are connected in sequence. The first portion 51 is disposed at least on the first surface 1a, the second portion 52 is disposed on the selected side surface 1cc, and the third portion 53 is disposed at least on the second surface 1b and is electrically connected to a second electrode 4 among the plurality of second electrodes 4.

It should be noted that the first portion 51 being disposed at least on the first surface 1a means that the first portion 51 is entirely located on the first surface 1a or partially located on the first surface 1a. The third portion 53 being disposed at least on the second surface 1b means that the third portion 53 is entirely located on the second surface 1b or partially located on the second surface 1b.

In some examples, the first surface 1a or the second surface 1b is directly connected to the selected side surface 1cc, that is, two borders, that are close to each other, of the first surface 1a and the selected side surface 1cc of the substrate 1 coincide with each other, and two borders, that are close to each other, of the second surface 1b and the selected side surface 1cc of the substrate 1 coincide with each other, then the first portion 51 may be entirely disposed on the first surface 1a, or the first portion 51 may also include a part extending to the selected side surface 1cc. It can be understood that the first portion 51 is continuous everywhere and is of a one-piece structure. The third portion 53 may be entirely disposed on the second surface 1b, or the third portion 53 may also include a portion extending to the selected side surface 1cc. It can be understood that the third portion 53 is continuous everywhere and is of a one-piece structure.

In some examples, a transition side surface may be provided between the selected side surface 1cc and the first surface 1a or second surface 1b. The transition side surface may be a plurality of surfaces connected in sequence, or may be a flat surface or an arc surface, which may be referred to FIGS. 2A and 2B. In this case, the first portion 51 may be entirely disposed on the first surface 1a, or the first portion 51 may include a part extending to the transition side surface between the first surface 1a and the selected side surface 1cc, or the first portion 51 may also include a part extending to the selected side surface 1cc. It will be understood that the first portion 51 is continuous everywhere and is of a one-piece structure. The third portion 53 may be entirely disposed on the second surface 1b, or the third portion 53 may include a portion extending to the transition side surface between the second surface 1b and the selected side surface 1cc, or the third portion 53 may also include a portion extending to the selected side surface 1cc. It will be understood that the third portion 53 is continuous everywhere and is of a one-piece structure. It will be understood that in some embodiments, the second portion 52 may also include a portion extending to the transition side surface.

Exemplarily, referring to FIGS. 2A and 2B, a first transition side surface 1d is provided between the selected side surface 1cc and the first surface 1a, and a second transition side surface 1e is provided between the selected side surface 1cc and the second surface 1b; the first surface 1a is connected to the selected side surface 1cc through the first transition side surface 1d, and the second surface 1b is connected to the selected side surface 1cc through the second transition side surface 1e; the connecting trace 5 extends from the first surface 1a to second surface 1b via the first transition side surface 1d, the selected side surface 1cc and the second transition side surface 1e. It can be understood that a part of the first portion 51 is located on the first surface 1a of the substrate 1, and another part of the first portion 51 may be located on the first transition side surface 1d between the first surface 1a and the selected side surface 1cc; a part of the third portion 53 is located on the second surface 1b of the substrate 1, and another part of the third portion 53 may be located on the second transition side surface 1e between the second surface 1b and the selected side surface 1cc.

It can be understood that providing first transition side surface 1d and the second transition side surface 1e is equivalent to providing a chamfer or rounded corner between the selected side surface 1cc and the first surface 1a or between the second surface 1b and the selected side surface 1cc, which may reduce collisions and the possibility of being scratched during the configuration of side wires.

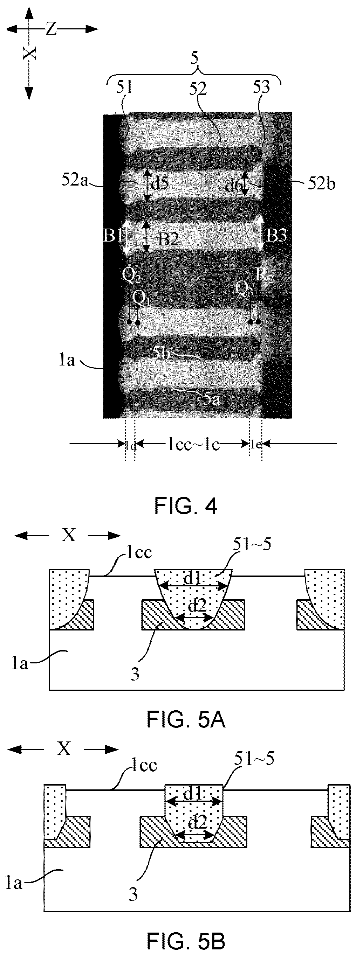

In some embodiments, referring to FIG. 4, for the connecting trace 5, the maximum width B1 of the first portion 51 in the first direction X and/or the maximum width B3 of the third portion 53 in the first direction X is greater than the maximum width B2 of the second portion 52 in the first direction X. The first direction X is a direction perpendicular to the overall extension direction of the connecting traces 5. Referring to FIGS. 2A, 2B and 3, the overall extension direction of the connecting traces 5 is referred to as a third direction Z.

Exemplarily, as shown in FIG. 4, the connecting trace 5 includes two opposite sides in the first direction X, namely a first side 5a and a second side 5b. A distance between the first side 5a and the second side 5b is a width of the connecting trace 5, and the maximum distance between the first side 5a and the second side 5b is the maximum width of the connecting trace 5.

It should be noted that at least part of the connecting trace is formed by three-dimensional printing. In some embodiments, the first portion 51, the second portion 52 and the third portion 53 of the connecting trace 5 are formed by printing three times. Referring to FIG. 4, during the process of forming the second portion 52 of the connecting trace 5, there is a need to ensure that the conductive paste is discharged at the predetermined starting position Q₂, and the dwell time of the three-dimensional printing device at the starting position Q₂ is longer than other positions on the printing path, so there will be a certain amount of material stacking, and a "big head" phenomenon will appear at the starting position Q₂, that is, the width of the second portion 52 at the starting position Q₂ is the maximum width of the second portion 52; moreover, the lengths of the first portion 51 and the third portion 53 of the connecting trace 5 is less than the length of the second portion 52, and the length required to be printed is small, during the actual printing process, the three-dimensional printing device moves slowly and has a long dwell time, so that the material stacking is more obvious, the maximum width B1 of the first portion 51 in the first direction X will be greater than the maximum width B2 of the second portion 52 in the first direction X, and the maximum width B3 of the third portion 53 in the first direction X will be greater than the maximum width B2 of the second portion 52 in the first direction X.

It can be understood that at least part of the connecting trace is formed by three-dimensional printing, that is, part or entire of the connecting trace is formed by three-dimensional printing. In the above description, the entire of the connecting trace being formed by a three-dimensional printing process or part of the connecting trace being formed by a three-dimensional printing process are divided into the following situations.

In some embodiments, the first portion 51 of the connecting trace 5 is formed by three-dimensional printing, and the second portion 52 and the third portion 53 of the connecting trace 5 are formed by other processes, such as pad printing or screen printing. The formed connecting trace 5 satisfies that the maximum width B1 of the first portion 51 in the first direction X is greater than the maximum width B2 of the second portion 52 in the first direction X.

In some embodiments, the third portion 53 of the connecting trace 5 is formed by three-dimensional printing, and the second portion 52 and the first portion 51 of the connecting trace 5 are formed by other processes, such as pad printing or screen printing. The formed connecting trace 5 satisfies that the maximum width B3 of the third portion 53 in the first direction X is greater than the maximum width B2 of the second portion 52 in the first direction X.

In some embodiments, the first portion 51 and the third portion 53 of the connecting trace 5 are formed by three-dimensional printing, and the second portion 52 of the connecting trace 5 is formed by other processes, such as pad printing process or screen printing. The formed connecting trace 5 satisfies that the maximum width B1 of the first portion 51 in the first direction X is greater than the maximum width B2 of the second portion 52 in the first direction X, and/or the maximum width B3 of the third portion 53 in the first direction X is greater than the maximum width B2 of the second portion 52 in the first direction X.

Exemplarily, part of a region of an orthographic projection of any one side of the first side 5a and the second side 5b obtained based on the above processes on the substrate 1 consists of arc segments, and a distance between the first side 5a and the second side 5b is not the same at everywhere. The maximum distance (i.e., the maximum width B1) between the first side 5a and the second side 5b located at the first portion 51 is greater than the maximum distance (i.e., the maximum width B2) between the first side 5a and the second side 5b located at the second portion 52, and/or the maximum distance (i.e., the maximum width B3) between the first side 5a and the second side 5b located at the third portion 53 is greater than the maximum distance (i.e., the maximum width B2) between the first side 5a and the second side 5b located at the second portion 52.

The connecting traces obtained by the above forming process have an anti-corrosion effect. This is because in the forming process, whether it is a three-dimensional printing process, a pad printing process or a screen printing process, conductive paste is used as the material of the connecting traces. The selected conductive paste is, for example, silver paste, which is mainly composed of silver particles and resin solvents, and the silver paste has the characteristics of rapid film formation and a dense oxide film may be formed on the surface of the silver paste, which may well protect the good conductive effect of itself; moreover, it is possible to avoid the problem of damage to the film layer on the front of the display panel 10 during the etching process by using the laser etching and the problem that after the connecting traces are formed, the etched surface of the connecting traces is exposed and prone to corrosion and its surface will be easily scratched.

It should be noted that in some embodiments, for the case that the connecting traces are formed by other processes, for example, the connecting traces are obtained by pad printing or screen printing, a design may be adopted to allow that the maximum width B1 of the first portion 51 in the first direction X to be greater than the maximum width B2 of the second portion 52 in the first direction X, and the maximum width B3 of the third portion 53 in the first direction X is greater than the maximum width B2 of the second portion 52 in the first direction X. That is to say, the dimension relationship between the various portions of the above-mentioned connecting trace is not limited to being obtained by three-dimensional printing, but may be designed to improve the electrical reliability of the connecting trace by designing the dimension relationships in structure.

Exemplarily, the first portion 51 of the connecting trace 5 and the first electrode 3 are of a one-piece structure and are formed through a single film formation or patterning process, which may also satisfy that the maximum width B1 of the first portion 51 in the first direction X is greater than the maximum width B2 of the second portion 52 in the first direction X, and the maximum width B3 of the third portion 53 in the first direction X is greater than the maximum width B2 of the second portion 52 in the first direction X.

Exemplarily, the third portion 53 of the connecting trace 5 and the second electrode 4 are of a one-piece structure and are formed through a single film formation or patterning process, which may also satisfy that the maximum width B1 of the first portion 51 in the first direction X is greater than the maximum width B2 of the second portion 52 in the first direction X, and the maximum width B3 of the third portion 53 in the first direction X is greater than the maximum width B2 of the second portion 52 in the first direction X.

In some embodiments, with continued reference to FIG. 4, the maximum width B1 of the first portion 51 in the first direction X is greater than the maximum width B2 of the second portion 52 in the first direction X.

Exemplarily, the forming process of the first portion 51 and the second portion 52 of the connecting trace 5 is the same as the above-mentioned forming process, and the achieved effect is similar to the above-mentioned connecting trace 5, which will not be repeated here.

In some embodiments, with continued reference to FIG. 4, the maximum width B3 of the third portion 53 in the first direction X is greater than the maximum width B2 of the second portion 52 in the first direction X.

Exemplarily, the forming process of the second portion 52 and the third portion 53 of the connecting trace 5 is the same as the above-mentioned preparation process, and the achieved effect is similar to the above-mentioned connecting trace 5, which will not be repeated here.

In some embodiments, as shown in FIGS. 5A and 5B, for at least one connecting trace 5, in at least two line segments, in the first direction X, of an orthographic projection pattern of the first portion 51 on the first surface 1a, a dimension d1 of a line segment proximate to the selected side surface 1cc in the first direction X is greater than a dimension d2 of another line segment away from the selected side surface 1cc in the first direction X.

It should be noted that the line segment here refers to a line segment between two points where a straight line extending in the first direction X intersects the boundary of the orthographic projection pattern of the first portion 51 on the first surface 1a.

In the following, considering two of the plurality of line segments, in the first direction X, of the orthographic projection pattern of the first portion on the first surface 1a as an example to describe the dimension relationship of the line segments.

Exemplarily, referring to FIGS. 5A and 5B, hereinafter, the line segment proximate to the selected side surface 1cc is referred to as a first type of line segment, and the line segment away from the selected side surface 1cc is referred to as a second type of line segment, and a dimension d1 of the first type of line segment in the first direction is greater than a dimension d2 of the first type of line segment in the first direction.

It should be noted that in the above description, only the dimension relationship between at least two of the plurality of line segments of the orthographic projection pattern of the first portion 51 is limited, i.e., the dimension relationship between the line segment proximate to the selected side surface 1cc and the line segment away from the selected side surface 1cc is limited, and the sizes of all the line segments are not limited. Therefore, referring to FIG. 5A, in a direction away from the selected side surface 1cc, the dimension of the line segment of the orthographic projection pattern of the first portion 51 on the first surface 1a in the first direction X gradually decreases, and the orthographic projection pattern of the first portion 51 has a tendency to gradually narrow as a whole; alternatively, referring to FIG. 5B, the orthographic projection pattern of the first portion 51 includes a first part and a second part, and the second part of the orthographic projection pattern of the first portion 51 away from the selected side surface 1cc narrows relative to the first part proximate to the selected side surface 1cc, and in the direction away from the selected side surface 1cc, a dimension of the first part, proximate to the selected side surface 1cc, of the orthographic projection of the first portion 51 remains unchanged, and the second part, away from the selected side surface 1cc, of the orthographic projection of the first portion 51 gradually narrows. The orthographic projection pattern of the first portion 51 on the first surface 1a shown in FIGS. 5A and 5B is not unique, as long as the structure is ensured to be wide at the top and narrow at the bottom, and FIGS. 5A and 5B are merely possible implementations.

The above dimension relationship is obtained based on that the process of forming connecting traces is a three-dimensional printing process. Referring to FIGS. 2A and 2B, a first transition side surface 1d is provided between the selected side surface 1cc and the first surface 1a of the substrate 1 shown in FIGS. 2A and 2B, and in the process of forming the first portion 51 of the connecting trace 5, in order to ensure that the conductive paste on the first transition side surface 1d has sufficient thickness, it can be known according to the foregoing content that a part of the first portion 51 is located on the first surface 1a of the substrate 1, and another part is on the first transition side surface 1d between the first surface 1a and the selected side surface 1cc. Therefore, referring to FIGS. 3 and 4, the starting position Q1 of the three-dimensional printing device corresponds to an end of the first portion 51 to be formed proximate to the selected side surface, which is located above the first transition side surface 1d, and an orthographic projection of the starting position Q1 on the first transition side surface 1d is the border of the first transition side surface 1d proximate to the selected side surface 1cc. In order to ensure that the conductive paste is discharged at the predetermined starting position Q1, the conductive paste accumulated at the starting position Q1 may sufficiently cover the first transition side surface 1d, and then the printing process is performed in a second direction Y; according to the flow characteristics of the conductive paste, it is obtained that for the first portion 51 of the connecting trace 5, a part away from the selected side surface 1cc narrows in a certain degree relative to the part proximate to the selected side surface 1cc. During the printing process, due to the change in speed and air pressure caused by movement, there is a certain fluctuation in the overall thickness of the first portion of the connecting trace, that is, the surface of the first portion 51 away from the substrate 1 has a certain roughness, and it should be noted that this roughness does not affect the resistance of the connecting trace 5, and may ensure the normal transmission of the signal of the display panel.

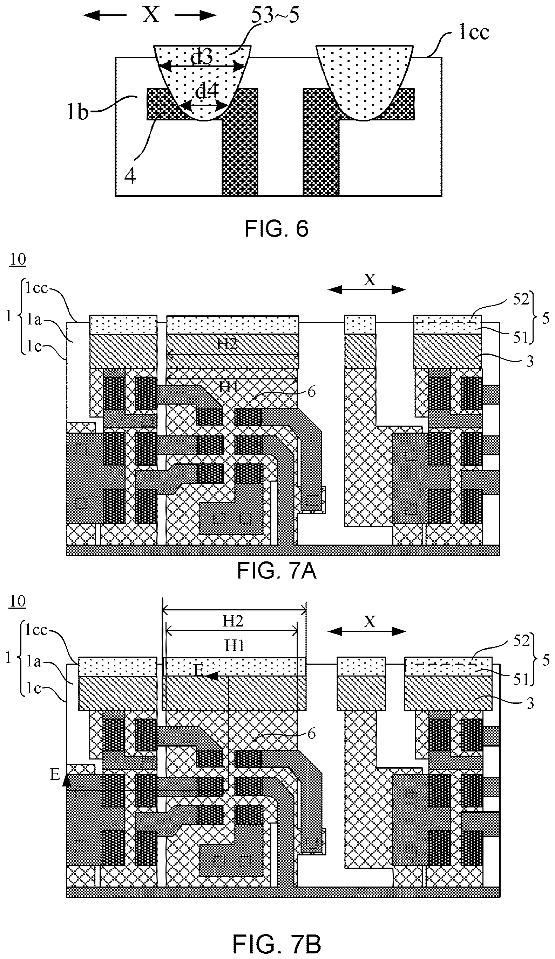

In some embodiments, referring to FIG. 6, for at least one connecting trace, among at least two line segments, in the first direction X, of an orthographic projection pattern of the third portion 53 on the second surface 1b, a dimension d3 of a line segment proximate to the selected side surface 1cc in the first direction X is greater than a dimension d4 of another line segment away from the selected side surface 1cc in the first direction X.

Exemplarily, the third portion 53 of the connecting trace 5 is also formed by using the above-mentioned three-dimensional printing process. Therefore, the effect that can be achieved is similar to the first portion 51 of the connecting trace 5 and will not be repeated here.

In some embodiments, referring to FIGS. 5A, 5B and 6, for at least one connecting trace 5, among at least two line segments, in the first direction X, of the orthographic projection pattern of the first portion 51 on the first surface 1a , the dimension d1 of the line segment proximate to the selected side surface 1cc in the first direction X is greater than the dimension d2 of the line segment away from the selected side surface 1cc in the first direction X; among at least two line segments, in the first direction X, of the orthographic projection pattern of the third portion 53 on the second surface 1b, the dimension d3 of the line segment proximate to the selected side surface 1cc in the first direction X is greater than the dimension d4 of the line segment away from the selected side surface 1cc in the first direction X.

Exemplarily, the first portion 51 and the third portion 53 of the connecting trace 5 are also formed by using the above-mentioned three-dimensional printing process. Therefore, the effect that can be achieved is similar to the above-mentioned first portion 51 of the connecting trace 5 and will not be repeated here.

In some embodiments, with continued reference to FIG. 4, the second portion 52 of the connecting trace 5 includes a first end 52a and a second end 52b, the first end 52a and the second end 52b are two opposite ends of the second portion 52 of the connecting trace 5 in an extension direction of the second portion 52 (i.e., the third direction Z), and a dimension d5 of the first end 52a in the first direction X is greater than a dimension d6 of the second end 52b in the first direction.

Exemplarily, according to the foregoing content, it can be known that the connecting traces are formed by three-dimensional printing. Referring to FIG. 4, in the process of forming the connecting traces 5, there is a need to ensure that the conductive paste is discharged at the predetermined starting position Q, and the dwell time of the three-dimensional printing device at the starting position Q is longer than other positions on the printing path, so there will be a certain amount of material stacking, and a "big head" phenomenon will appear at the starting position Q; while when it is close to the printing end position R, the three-dimensional printing device needs to be turned off in advance, and the remaining conductive paste attached to the three-dimensional printing device may be enough to complete the line printing process, so the line width at the end position R is less than the line width at the starting position Q. That is to say, in the process of forming the second portion of the connecting trace, the starting position Q₂ of the three-dimensional printing device corresponds to the first end 52a of the second portion 52 of the connecting trace 5, and the end position R of the three-dimensional printing device corresponds to the second end 52b of the second portion 52 of the connecting trace 5, so the dimension d5 of the first end 52a in the first direction X is greater than the dimension d6 of the second end 52b in the first direction.

In some embodiments, referring to FIG. 3, the first portion 51 partially overlaps with the first electrode 3, and the third portion 53 partially overlaps with the second electrode 4.

It can be understood that orthographic projections, on the first surface 1a of the substrate 1, of the first portion 51 and the first electrode 3 partially overlap with each other; for example, the first portion 51 covers the end of the first electrode 3 proximate to the selected side surface 1cc, which may ensure that the electrical connection between the first portion 51 and the first electrode 3 is fully achieved. Orthographic projections, on the second surface 1b of the substrate 1, of the third portion 53 and the second electrode 4 overlap with each other; for example, the third portion 53 covers the end of the second electrode 4 proximate to the selected side surface 1cc, which may ensure that the electrical connection between the third portion 53 and the second electrode 4 is fully achieved.

In some embodiments, referring to FIG. 2A, the display panel 10 includes a plurality of signal lines 6 disposed on the first surface 1a, and the plurality of signal lines 6 electrically connect the plurality of first electrodes 3 to the plurality of light-emitting devices 2. Referring to FIGS. 7A and 7B, each signal line 6 is electrically connected to a first electrode 3, and a dimension H1 of the signal line 6 in the first direction X is not greater than a dimension H2 of the first electrode 3 in the first direction X.

Exemplarily, as shown in FIG. 7A, FIG. 7A is diagram showing a connection structure of the signal line 6 and the first electrode 3. From this figure, it can be obtained that the dimension H1 of the signal line 6 in the first direction X is equal to the dimension H2 of the first electrode 3 in the first direction X, so as to ensure full contact between the two to achieve electrical connection.

Exemplarily, as shown in FIG. 7B, FIG. 7B is a diagram showing another connection structure of the signal line 6 and the first electrode 3. From this figure, it can be obtained that the dimension H1 of the signal line 6 in the first direction X is less than the dimension H2 of the first electrode 3 in the first direction X. By setting such a dimension relationship in this connection manner, it is possible to ensure that in a case where the first electrode 3 is electrically connected to the connecting trace 5, the contact area between the first electrode 3 and the first portion 51 of the connecting trace 5 is increased, thereby reducing the contact resistance and further improving the signal transmission efficiency, so as to enhance the display effect of the display panel 10.

It should be noted that, referring to FIGS. 7A and 7B, since the types of signals that the plurality of signal lines 6 on the first surface 1a transmit are different, widths of the plurality of signal lines 6 in the first direction X are not completely the same; a width of the first electrode 3 in the first direction X is positively correlated with a width of the signal line 6 to which it is connected.

Exemplarily, the width of the connecting trace 5 in the first direction X is positively correlated with the width of the first electrode 3 to which it is connected in the first direction X.

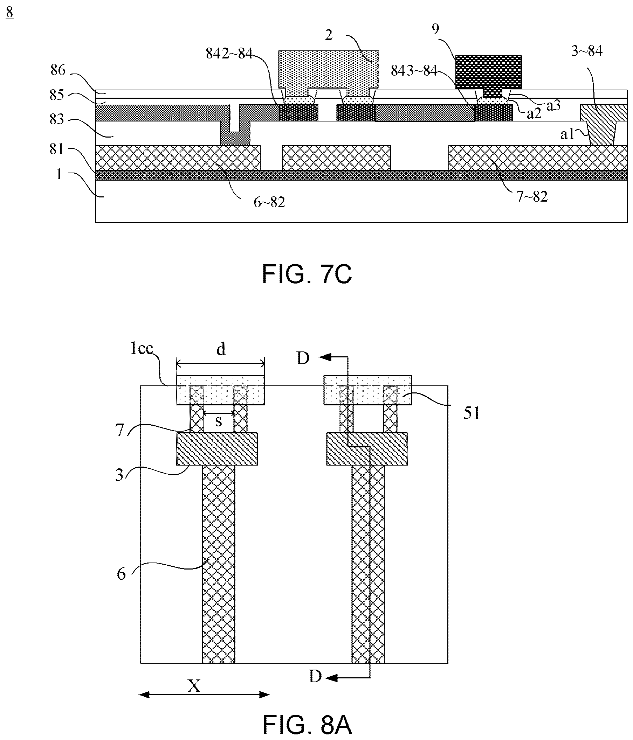

In some embodiments, referring to the film layer structure diagram shown in FIG. 7C, the substrate 1 is provided thereon with a driving circuit layer 8, which includes a buffer layer 81, a first metal layer 82, an insulating layer 83, a second metal layer 84, a planarization layer 85 and a passivation layer 86.

The buffer layer 81 is disposed on a side of the first surface 1a; the first metal layer 82 includes a plurality of signal lines 6 and extension lines 7. The insulating layer 83 is disposed on a side of the first metal layer 82 away from the substrate 1. The second metal layer 84 is disposed on a side of the insulating layer 83 away from the substrate 1, and the second metal layer 84 includes the plurality of first electrodes 3. The planarization layer 85 is disposed on a side of the second metal layer 84 away from the substrate 1. The passivation layer 86 is disposed on a side of the planarization layer 85 away from the substrate 1. The insulating layer 83 includes a plurality of first via holes a1, and each first electrode 3 of the plurality of first electrodes 3 is electrically connected to the signal line 6 in the first metal layer 82 through a corresponding first via hole a1. It will be understood that a part of the first electrode 3 is located in the first metal layer 82, and another part is located in the second metal layer 84.

In some embodiments, as shown in FIG. 7C, the second metal layer 84 further includes a plurality of connection pads, the plurality of connection pads include a plurality of first pads 842 for connecting the light-emitting device 2 and a plurality of second pads 843 for connecting pixel driving chips 9.

Specifically, as shown in FIG. 7C, the pins of the light-emitting device 2 and the pins of the pixel driving chip 9 are connected to the respective connection pads by soldering materials (e.g., soldering tin, tin-silver-copper alloy, tin-copper alloy). The planarization layer 85 includes a plurality of second via holes a2, and the plurality of second via holes a2 penetrate to the second metal layer 84. The passivation layer 86 includes a plurality of third via holes a3, and the plurality of third via holes a3 penetrate to the planarization layer 85. A third via hole a3 corresponds to a second via hole a2 in position, forming a through hole penetrating from the passivation layer 86 to the connection pad of the second metal layer 84.

Exemplarily, as shown in FIG. 7C, each light-emitting device 2 includes two connection pins, each pixel driving chip 9 includes six connection pins, and the pins of each light-emitting device 2 are connected to two first pads 842 through the through holes penetrating both the planarization layer 85 and the passivation layer 86, and the pins of each pixel driving chip 9 are connected to six second pads 843 through the via holes penetrating both the planarization layer 85 and the passivation layer 86, thereby controlling the light-emitting device 41 to emit light under the control of the pixel driving chip 9 and the signal transmitted by the signal line 6.

In some embodiments, the first metal layer 82 or the second metal layer 84 is a metal layer including multiple stacked structures. For example, the first metal layer 82 or the second metal layer 84 may include a titanium layer, a copper layer, and a titanium layer that are arranged in sequence from a side of the substrate 1. Alternatively, the first metal layer 82 or the second metal layer 84 may include, for example, a molybdenum layer, a copper layer, and a molybdenum layer that are arranged in sequence from a side of the substrate 1. Alternatively, the first metal layer 82 or the second metal layer 84 includes, for example, a molybdenum layer, an aluminum layer, and a molybdenum layer that are arranged in sequence from a side of the substrate 1.

In some embodiments, the first metal layer 82 or the second metal layer 84 is a signal wiring layer with a single-layer structure. Further, the driving circuit layer is, for example, a copper layer or an aluminum layer.

Specifically, the description here is only illustrative and does not limit the material used in the driving circuit layer 8, as long as the first metal layer 82 or the second metal layer 84 has good conductive performance.

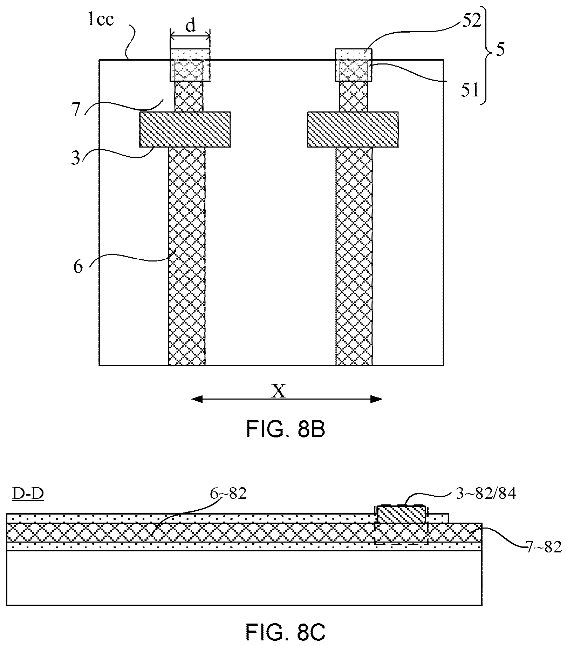

In some embodiments, as shown in FIGS. 8A and 8B, the display panel 10 further includes at least one extension line 7 provided on a side of at least one first electrode 3 proximate to the selected side surface 1cc, and the at least one extension line 7 is electrically connected to the first electrode 3; the at least one extension line 7 is electrically connected to a connecting trace 5.

Exemplarily, as shown in FIGS. 8A and 8B, at least one extension line 7 is disposed on the side of at least one first electrode 3 proximate to the selected side surface 1cc; for example, a first electrode corresponds to one extension line 7 or multiple extension lines 7, the extension line 7 extends from the first electrode 3 to the border of the first surface 1a, and the first electrode 3 is connected to a corresponding connecting trace 5 through the extension line 7.

Exemplarily, at least one extension line 7 is disposed on the side of each first electrode 3 proximate to the selected side surface 1cc; as shown in FIG. 8A, two extension lines 7 are disposed on the side of each first electrode 3 proximate to the selected side surface 1cc, and each first electrode 3 is connected to a corresponding connecting trace 5 through the corresponding extension lines 7.

It should be noted that one or more extension lines 7 are disposed on the side of a first electrode 3 proximate to the selected side surface 1cc, and the extension line 7 extends to the boundary between the first surface and the selected side surface. Due to the provision of the extension line(s) 7, the contact reliability between the first electrode 3 and the connecting trace 5 may be improved, and the transmission resistance may be reduced to improve the signal transmission efficiency, thereby improving the yield of the display panel.

Exemplarily, referring to FIG. 8A, two extension lines 7 are taken as an example in this figure. The two extension lines 7 are electrically connected to one first electrode 3, any one of the two extension lines 7 is electrically connected to the first electrode 3, and any one of the two extension lines 7 is electrically connected to the connecting trace 5. It will be understood that in a case where any one of the two extension lines 7 is damaged, the other extension line 7 may still play a role of transmitting signals, thereby ensuring that the signal transmission of the display panel 10 is stable.

In some embodiments, continuing to refer to FIG. 8A, the number of extension line 7 electrically connected to the first electrode 3 is multiple, and among the multiple extension lines 7 corresponding to one first electrode 3, a spacing s between any two extension lines 7 is greater than or equal to 60 µm.

Exemplarily, as shown in FIG. 8A, the number of extension line 7 electrically connected to the first electrode 3 is multiple, for example, two. By limiting the spacing between any two extension lines 7, it is possible to ensure that the film layer will not fall off during the subsequent edge grinding process to prevent certain damage to the extension lines 7.

It should be noted that in a case where the extension line 7 is provided, a width of the extension line 7 in the first direction X is positively correlated with a width of the first electrode 3 to which it is connected in the first direction X, and the width of the connecting trace 5 in the first direction X is positively correlated with the width of the extension line 7 to which it is connected in the first direction X.

In some embodiments, the width of each extension line 7 in the first direction X is not the same.

In some embodiments, the width of each extension line 7 in the first direction X is the same, and the width of each connecting trace 5 in the first direction X is the same. Based on such an arrangement, the structure of equipment and the process used to form the connecting trace 5 may be simplified, and the productivity may be improved at a relatively low cost.

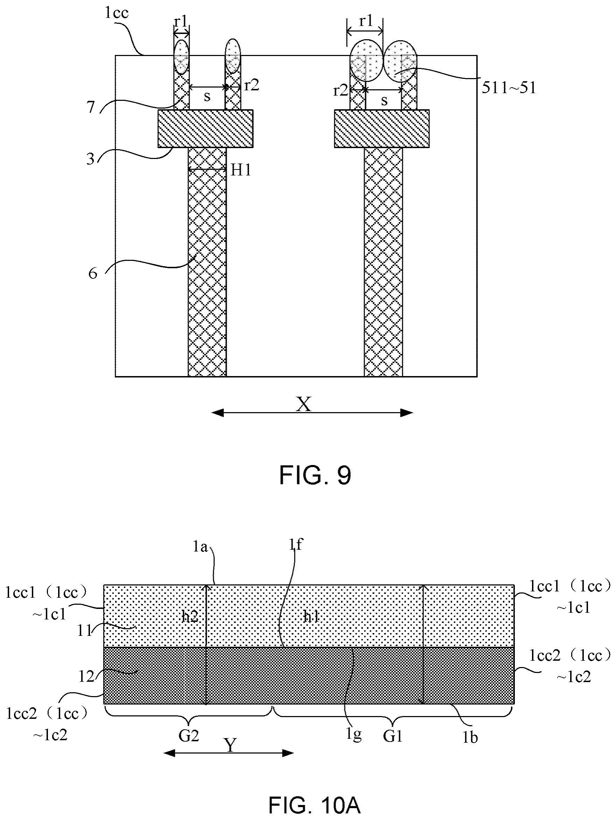

In some embodiments, referring to FIGS. 8A, 8B and 9, the first electrode 3 is connected to the connecting trace 5, at least two extension lines 7 are disposed on the side of the first electrode 3 proximate to the selected side surface 1cc, and the at least two extension lines 7 are electrically connected to the first portion 51 of the connecting trace 5. The at least two extension lines 7 may be electrically connected to the first portion 51 of the connecting trace 5 in the following manners.

In some examples, as shown in FIG. 8A, the dimension d of the first portion 51 in the first direction X is greater than the spacing s between two extension lines 7, and the two extension lines 7 are both in contact with the first portion 51.

Exemplarily, referring to FIG. 8A, the dimension d of the first portion 51 in the first direction X is configured to be greater than the spacing s between two extension lines 7, the first portion 51 here is a whole pattern, and the dimension d of the first portion 51 may cover the spacing s between two extension lines, which allows the entire first portion 51 to fully lap the two extension lines 7 to achieve electrical connection, thereby achieving effective signal transmission.

It should be noted that in the process of forming the first portion of the connecting trace by three-dimensional printing, in a case where the print head is relatively thick, it only needs to print once to lap both the two extension lines 7.

In some other examples, referring to FIG. 9, the first electrode 3 is connected to the connecting trace 5, at least two extension lines 7 are disposed on the side of the first electrode 3 proximate to the selected side surface 1cc, the first portion 51 of the connecting trace 5 includes at least two sub-portions 511, and a dimension r1 of any sub-portion 511 in the first direction X is not less than a dimension r2 of any extension line 7 in the first direction X; and the at least two sub-portions 511 overlap with the at least two extension lines 7 respectively. That is to say, the first portion 51 is divided into at least two parts, the number of the sub-portions 511 corresponds to the number of the extension lines 7, and the sub-portions 511 and the extension lines 7 overlap in one-to-one correspondence to achieve corresponding connections.

It should be noted that in the process of forming the first portion of the connecting trace by three-dimensional printing, in a case where the print head is relatively thin, it needs to print twice to connect both the two extension lines 7.

Exemplarily, referring to FIG. 9, the dimension r1 of any sub-portion 511 in the first direction X is configured to be equal to the dimension r2 of any extension line 7 in the first direction X, and the at least two sub-portions 511 is configured to overlap with the at least two extension lines 7 respectively, which may ensure that the two sub-portions 511 included in the first portion 51 respectively lap the two extension lines 7 to achieve electrical connection, thereby achieving effective signal transmission.

Exemplarily, with continued reference to FIG. 9, the dimension r1 of any sub-portion 511 in the first direction X is greater than the dimension r2 of any extension line 7 in the first direction X, i.e., r1 > r2, and under the limitation of such a dimension, the two sub-portions 511 formed by the three-dimensional printing device are in contact with each other on the sides where the two sub-portions 511 are close to each other, and the at least two sub-portions 511 respectively overlap with the at least two extension lines 7. In this way, the lapping area between any sub-portion 511 and any extension line 7 may be increased, thereby reducing contact resistance, further improving signal transmission efficiency, and enhancing the display effect of the display panel 10.

It should be noted that the dimension relationship between the dimension r1 of any sub-portion 511 in the first direction X and the dimension r2 of any extension line 7 in the first direction X is limited here, it is possible to ensure that the sub-portion is in fully contact with the extension line, so that the electrical signals may be efficiently transmitted.

In some embodiments, the dimension r2 of the extension line 7 in the first direction X is less than or equal to 30 µm.

Exemplarily, the dimension r2 of the extension line 7 in the first direction X is less than 30 µm, such as 20 µm, or 25 µm.

In some embodiments, referring to FIG. 8C, the plurality of signal lines 6 and the extension lines 7 are formed by the first metal layer 82, and the plurality of first electrodes 3 are formed by the first metal layer 82 and the second metal layer 84. The second metal layer 84 is further away from the first surface 1a than the first metal layer 82.

Exemplarily, referring to FIG. 8C, FIG. 8C is a sectional view of FIG. 8A taken along the section line DD, the extension line 7 and the signal line 6 are both located in the first metal layer 82, an insulating layer is provided on both sides of the first metal layer 82 proximate to and away from the substrate 1. The first electrode 3 is connected to the first metal layer 82 through a via hole in the insulating layer that is located on the side away from the substrate 1. It can be known from this figure that a part of the first electrode 3 is located in the first metal layer 82, and the other part of the first electrode 3 is located in the second metal layer 84, so that the electrical connection between the extension line 7 and the signal line 6 is achieved.

In some embodiments, as shown in FIG. 9, for the signal line 6 and the extension line 7 that are connected to each other, a dimension H1 of the signal line 6 in the first direction X is greater than a dimension r2 of the extension line 7 in the first direction.

Exemplarily, the signal line 6 may be electrically connected to the extension line 7 through the first electrode 3, the dimension H1 of the signal line 6 in the first direction X is limited to be greater than the dimension r2 of the extension line 7 in the first direction. Since the number of extension line 7 electrically connected to the first electrode 3 may be multiple, the dimension r2 of each extension line 7 in the first direction is less than the dimension H2 of the first electrode 3 in the first direction. In some examples, the dimensions of the signal line 6 and the first electrode 3 in the first direction X are equal. Therefore, it can be seen that the dimension H1 of the signal line 6 in the first direction X is greater than the dimension r2 of the extension line 7 in the first direction.

As mentioned above, the substrate 1 in the present disclosure is a double-sided substrate; the structure formed on the front of the substrate includes a plurality of light-emitting devices, a plurality of first electrodes, and a plurality of signal lines; the plurality of signal lines are electrically connected to the light-emitting devices; the structure formed on the back of the substrate includes a plurality of second electrodes. A plurality of connecting traces are provided on the side surface of the substrate. An end of the connecting trace is connected to the first electrode on the front and the other end of the connecting trace is connected to the second electrode on the back of the substrate to transmit signals to the plurality of light-emitting devices to achieve image display of the display panel.

In some embodiments, a double-sided substrate generally uses a double-sided array process to fabricate circuits on the front and back of the substrate. Since the electrodes on the substrate are formed by processes such as electroplating, evaporating, or wet etching, in the actual process of fabricating the circuits on the back of the substrate, there is a need to turn the substrate over after fabricating the structure on one surface of the substrate, and then fabricate the structure on the other surface of the substrate. In this process, it is inevitable that one surface of the substrate will be in contact with the device base, causing the surface of the substrate to be scratched or soiled. Scratches or dirt may cause short circuits, affecting the yield and quality of the display panel. Meanwhile, the above-mentioned manufacturing process has multiple steps and is complex, the manufacturing cost is relatively high, and the manufacturing efficiency is relatively low. Therefore, in order to simplify the overall manufacturing process of the display panel, the substrate of the display panel is formed by bonding two single-sided substrates, as detailed below.

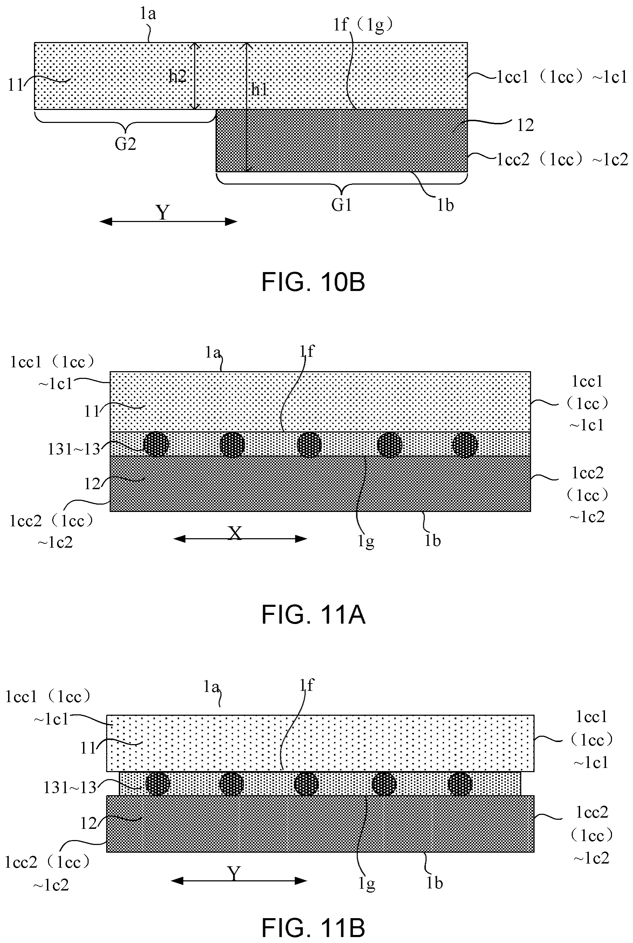

In some embodiments, as shown in FIGS. 10A and 10B, the substrate 1 includes a first substrate 11 and a second substrate 12; the first substrate 11 includes a first surface 1a and a third surface 1f opposite to each other, and a plurality of first side surfaces 1c1 connecting the first surface 1a and the third surface 1f; the second substrate 12 includes an fourth surface 1g and a second surface 1b opposite to each other, and a plurality of second side surfaces 1c2 connecting the fourth surface 1g and the second surface 1b; the third surface 1f and the fourth surface 1g are close to each other; at least one of the plurality of first side surfaces 1c1 is a first selected side surface 1cc1, at least one of the plurality of second side surfaces 1c2 is a second selected side surface 1cc2, the first selected side surface 1cc1 and the second selected side surface 1cc2 are located in a same plane and constitute a selected side surface 1cc of the substrate.

It will be understood that the substrate 1 includes the first substrate 11 and the second substrate 12, the first substrate 11 and the second substrate 12 are arranged oppositely, the first surface 1a of the first substrate 11 is the first surface 1a of the substrate 1, the second surface 1b of the second substrate 12 is the second surface 1b of the substrate 1, the third surface 1f of the first substrate 11 and the fourth surface 1g of the second substrate 12 are close to each other. By providing the first substrate 11 and the second substrate 12 as described above, related devices are fabricated on the first surface 1a and the second surface 1b corresponding to the first substrate 11 and the second substrate 12 respectively; the related devices fabricated on the first substrate 11 are the first electrodes 3, the light-emitting devices 2, the driving circuit layer 8, etc.; the related devices fabricated on the second substrate 12 are the second electrodes 4; then, the first substrate 11 and the second substrate 12 are combined into one substrate 1; finally, side traces are formed on the side of the substrate 1. Thus, there is no need to turn it over during the process of fabricating the film layer structure on the substrate, which may prevent scratches and electrostatic discharge problems caused by a fact that the substrate is in contact with the device; moreover, since the related devices on the substrate are fabricated on the first substrate 11 and the second substrate respectively, there will be no laser damage problem caused by the laser etching pattern on one side of the substrate to the film layer that has been formed on the other side of the substrate.

Exemplarily, referring to FIG. 10A, the first substrate 11 and the second substrate 12 have a same dimension in the second direction Y, there are two first selected side surface 1cc1 and two second selected side surface 1cc2, and the first selected side surface 1cc1 and the second selected side surface 1cc2 are located in a same plane. That is to say, the first selected side surface 1cc1 and the second selected side surface 1cc2 that are located on the same side constitute the selected side surface 1cc of the substrate 1. Therefore, two selected side surfaces 1cc of the substrate 1 are provided.

Exemplarily, referring to FIG. 10B, the dimension of the first substrate 11 in the second direction Y is greater than the dimension of the second substrate 12 in the second direction Y; one selected side surface 1cc of the substrate 1 is constituted, and the first selected side surface 1cc1 of the first substrate 11 and the second selected side surface 1cc2 of the second substrate 12 are located on the same plane.

In some embodiments, referring to FIG. 10B, the second surface 1b includes a first region G1 and a second region G2. There is a first distance h1 between the first region G1 and the first surface 1a, there is a second distance h2 between the second region G2 and the first surface 1a, and the first distance h1 is greater than the second distance h2.

Exemplarily, an orthographic projection area of the first region G1 of the second surface 1b on the first surface 1a and an orthographic projection area of the second substrate 12 on the first surface 1a are the same, the first region G1 is a part where the second substrate 12 is located, and the second region G2 is a remaining exposed part of the third surface 1f of first substrate 11 except for the part covered by the second substrate 12, that is, the second surface 1b of the substrate 1 here includes a part of the third surface 1f of the first substrate 11. In other words, an area of the second substrate 12 is less than an area of the first substrate 11. There is a first distance h1 between the first region G1 and the first surface 1a, and the first distance h1 here is a sum of a thickness of the first substrate 11 and a thickness of the second substrate 12. There is a second distance h2 between the second region G2 and the first surface 1a, and the second distance h2 here is the thickness of the first substrate 11. Therefore, the first distance h1 is greater than the second distance h2.

In some embodiments, referring to FIG. 10B, the first distance h1 is twice the second distance h2.

Exemplarily, in order to facilitate the fabrication of the substrates, the thicknesses of the substrates may be set to be the same, then the thickness of the first substrate 11 and the second substrate 12 are the same, that is to say, the first distance h1 is twice the second distance h2.

In some embodiments, referring to FIGS. 11A and 11B, the substrate 1 further includes an adhesive layer 13; the adhesive layer 13 is disposed between the third surface 1f and the fourth surface 1g and configured to bond the third surface 1f and the fourth surface 1g together.

Exemplarily, the adhesive layer 13 is disposed between the third surface 1f and the fourth surface 1g, that is to say, the adhesive layer 13 is disposed between the first substrate 11 and the second substrate 12, so as to closely bond the third surface 1f of the first substrate 11 and the fourth surface 1g of the second substrate 12 together.

In some embodiments, referring to FIGS. 11A and 11B, a material of the adhesive layer 13 is a thermal curing or ultraviolet (UV) curing material, and a plurality of silicon balls 131 are evenly arranged in the adhesive layer 13.

Exemplarily, referring to FIGS. 11A and 11B, a plurality of silicon balls 131 are evenly arranged in the adhesive layer 13, and the sizes of the silicon balls 131 are consistent to ensure the evenness of the bonding between the third surface 1f of the first substrate 11 and the fourth surface 1g of the second substrate 12, so as to improve the quality of the display panel.

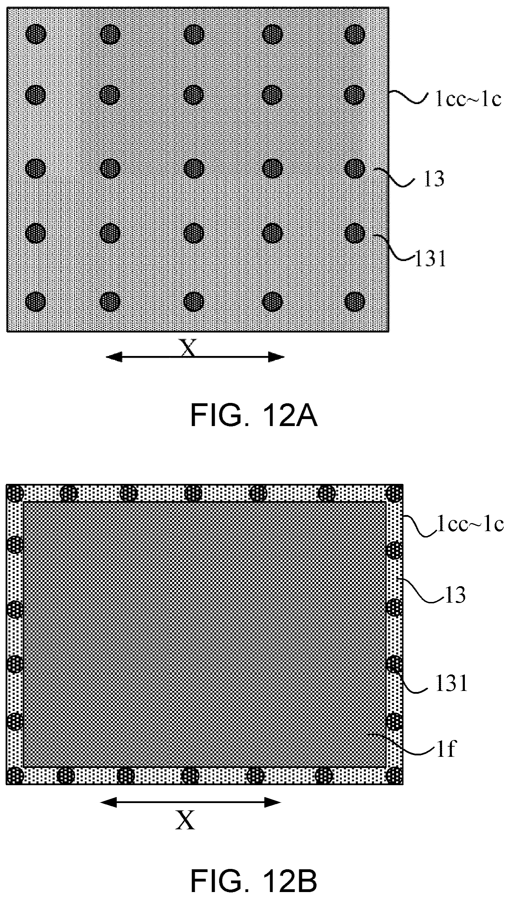

In some embodiments, referring to FIGS. 11A and 12A, an orthographic projection area of the adhesive layer 13 on the fourth surface 1g is equal to an area of the fourth surface 1g. That is to say, the adhesive layer 13 extends between the first substrate 11 and the second substrate 12, and is arranged corresponding to the first substrate 11 and the second substrate 12.

In some embodiments, referring to FIGS. 11B and 12B, an orthographic projection of the adhesive layer 13 on the fourth surface 1g is of a frame-shaped structure, and the frame-shaped structure is disposed on the edge of the fourth surface 1g. That is to say, there may be a certain distance between the outer contour of the adhesive layer 13 and the outer contour of the fourth surface 1g of the second substrate 12, so as to prevent the problems that it is not conducive to simplifying the process and the problem of increasing of the cost caused by a case that the material of the adhesive layer 13 exceeds the outer contour of the fourth surface 1g of the second substrate 12 during the manufacturing process.

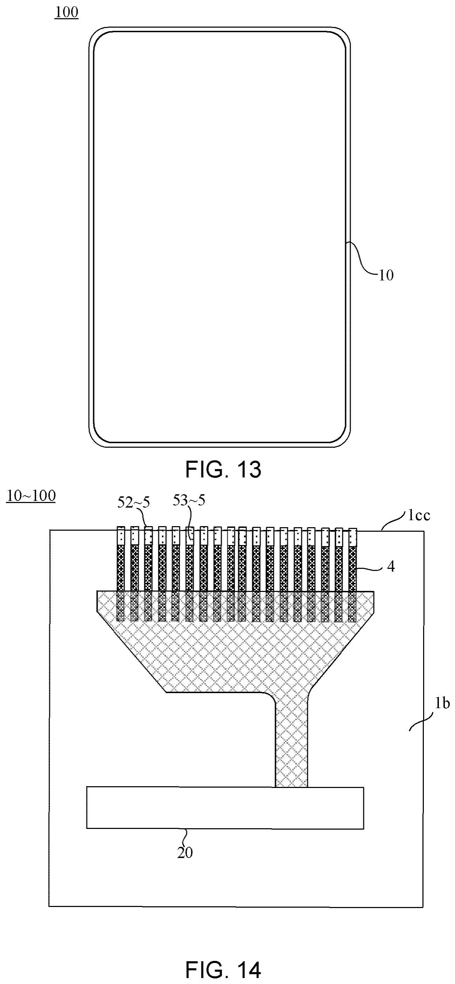

As shown in FIGS. 13 and 14, some embodiments of the present disclosure also provide a display apparatus 100, which includes the display panel 10 as described in any of the above embodiments and a driving circuit board 20. The driving circuit board 20 is disposed on the second surface 1b of the substrate 1 of the display panel 10, and the driving circuit board 20 is electrically connected to a plurality of connecting traces 5 of the display panel 10.

Exemplarily, the driving circuit board 20 is electrically connected to a plurality of second electrodes 4 to be electrically connected to the plurality of connecting traces 5 through the plurality of second electrodes 4, thereby transmitting signals and voltages to the light-emitting devices to achieve display of the display panel 10.

Exemplarily, the display apparatus 100 may be a mini light-emitting diode (mini LED) display apparatus or a micro light-emitting diode (micro LED) display apparatus.

In some examples, as shown in FIGS. 1, 2A, 2B and 14, compared with traditional LEDs, the light-emitting devices 2 using mini LEDs or micro LEDs occupy smaller space and have smaller size, within the same screen size, the density of light sources per unit area is higher and unit size of the light source is smaller, so that more precise local control for the light-emitting devices 2 may be achieved, which may ensure the uniformity of the display brightness and thereby ensure the display quality of the display device 100.

The display apparatus 100 adopts the display panel 10 as provided in the above embodiments, and the display apparatus 100 has the same technical effects as the above-mentioned display panel 10, which will not be repeated here.

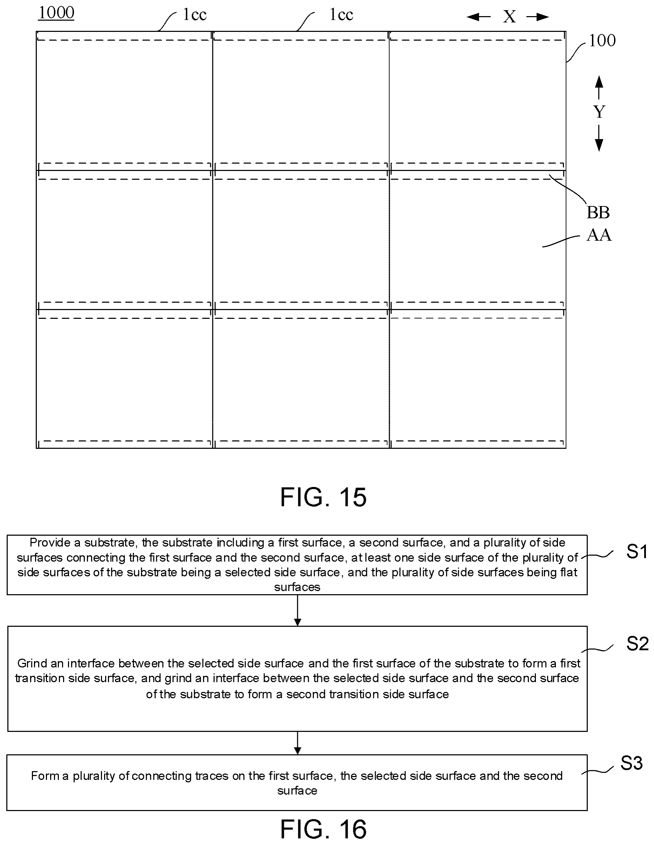

Some embodiments of the present disclosure also provide a tiled display apparatus 1000. As shown in FIG. 15, the tiled display apparatus 1000 includes a plurality of display apparatus 100 as provided in the above embodiments, and the selected side surfaces 1cc of the display apparatuses 100 located in the same column or same row are located on the same side.

Exemplarily, the plurality of display apparatuses 100 in the tiled display apparatus 1000 are arranged in an array. The tiled display apparatus 1000 may realize the display of a large image. For example, the tiled display apparatus 1000 may be used as an advertising tiled screen, a conference tiled screen, etc.

Exemplarily, as shown in FIG. 15, the display apparatus 100 is in a shape of a rectangle.

Referring to FIGS. 15 and 1, in the display panel 10, a plurality of first electrodes 3 are arranged in parallel in the first direction X. Correspondingly, a plurality of connecting traces 5 are also arranged in parallel in the first direction X. Another direction parallel to the display surface of the display apparatus 100 and perpendicular to the first direction X is referred to as a second direction Y. The display apparatus 100 includes a plurality of side surfaces. In the following description, among the plurality of side surfaces of the display apparatus 100, the side surface proximate to the peripheral area BB of the substrate 1 is referred to as a selected side surface of the display apparatus 100.

Exemplarily, as shown in FIGS. 1, 2A and 2B, the display panel 10 includes a display area AA and a peripheral area BB located on a side of the display area AA, a plurality of connecting traces 5 and a plurality of first electrodes 3 are arranged close to the peripheral area BB of the substrate 1.

Further, as shown in FIG. 15, in a case where a plurality of display apparatuses 100 including the display panel 10 shown in FIG. 1, FIGS. 2A and 2B are tiled, the selected side surfaces of two adjacent display apparatuses 100 are both arranged in the first direction X. In this way, in the plurality of display apparatuses 1000 arranged in a row in the first direction X, there is barely no tiling seam between two adjacent display apparatuses 100 in the first direction X; there is a tiling seam between two adjacent display apparatuses 100 in the plurality of display apparatuses 100 arranged in a column in the second direction Y. That is to say, the size of the tiling seam between two adjacent display apparatuses in the plurality of display apparatuses 100 arranged in a row in the first direction X is less than the size of the tiling seam between two adjacent display apparatuses 100 in the plurality of display apparatuses 100 arranged in a column in the second direction Y.

However, the dimension of the peripheral area BB in the second direction Y is very small. Therefore, when actually viewing the tiled display apparatus 1000, the tiling seam between two adjacent display apparatuses 100 is relatively difficult to detect with the naked eye within the viewing distance, so that the display image of the tiled display device 1000 is relatively complete and a decent display effect may be presented.

The tiled display apparatus 1000 adopts the display apparatus 100 as provided in the above embodiments, and the tiled display apparatus has the same technical effects as the above-mentioned display apparatuses 100, which will not be repeated here.

Some embodiments of the present disclosure also provide a manufacturing method of display panel 10, and as shown in FIG. 16, the manufacturing method of display panel 10 includes the following steps.

In S1, a substrate 1 is provided.

As shown in FIGS. 1, 2A and 2B, the substrate 1 includes a first surface 1a, a second surface 1b, and a plurality of side surfaces 1c connecting the first surface 1a and the second surface 1b. At least one side surface 1c of the plurality of side surfaces 1c of the substrate 1 is a selected side surface 1cc. The plurality of side surfaces 1c are flat surfaces.

Exemplarily, the first surface 1a includes a display area AA and a peripheral area BB located on at least one side of the display area AA, and the peripheral area BB is closer to the selected side surface 1cc of the substrate 1 than the display area AA.

In some examples, a material of the substrate 1 is, for example, a rigid material such as glass or quartz.

Exemplarily, referring to FIG. 10B, the second surface 1b includes a first region G1 and a second region G2. There is a first distance h1 between the first region G1 and the first surface 1a, there is a second distance h2 between the second region G2 and the first surface 1a, and the first distance h1 is greater than the second distance h2. For example, referring to FIG. 16, the first distance h1 is twice the second distance h2.

Exemplarily, referring to FIG. 10A, the first region G1 and the second region G2 included in the second surface 1b are located in the same plane. That is to say, the distance between the first region G1 and the first surface 1a is equal to the distance between the second region G2 and the first surface 1a, i.e., the first distance h1 is equal to the second distance h2.

It should be noted that the substrate 1 provided in S1 is a substrate with corresponding film layer structures formed on the first surface and the second surface.

In S2, referring to FIGS. 2A, 2B and 3, an interface between the selected side surface 1cc and the first surface 1a of the substrate 1 is ground to form a first transition side surface 1d, and an interface between the selected side surface 1cc and the second surface 1b of the substrate 1 is ground to form a second transition side surface 1e.

It should be noted that, referring to FIGS. 2A, 2B and 3, by forming the first transition side surface 1d and the second transition side surface 1e, it is ensured that a smooth transition connection may be achieved during the process of fabricating the side traces, which may further disperse stress, thereby ameliorating the problems of collision and edge and corner chipping caused by excessive stress concentration, thereby enhancing the reliability of the display panel.

In S3, referring to FIGS. 1 and 3, a plurality of connecting traces 5 are formed on the first surface 1a, the selected side surface 1cc and the second surface 1b.

Referring to FIGS. 1 and 3, the plurality of connecting traces 5 are arranged in parallel and at intervals; each connecting trace 5 of the plurality of connecting traces 5 includes a first portion 51, a second portion 52 and a third portion 53 that are connected in sequence; the first portion 51 is disposed at least on the first surface 1a, and the first portion 51 is electrically connected to one of the plurality of first electrodes 3; the second portion 52 is disposed on the selected side surface 1cc; the third portion 53 is disposed at least on the second surface 1b and is electrically connected to one of the plurality of second electrodes 4.

In some embodiments, referring to FIG. 4, a maximum width B1 of the first portion 51 in the first direction X and/or a maximum width B3 of the third portion 53 in the first direction X is greater than a maximum width B2 of the second portion 52 in the first direction X.

It should be noted that in the process of fabricating the connecting traces, the above-mentioned relationships of the width dimensions may be referred to the descriptions in the foregoing parts, and will not be repeated here.

Exemplarily, among the first portion 51, the second portion 52 and the third portion 53 of the connecting trace 5, the two connected portions overlap with each other. Referring to FIG. 3, since the first portion 51 and the third portion 53 of the connecting trace 5 are formed before the second portion 52 of the connecting trace 5, as can be seen in FIGS. 3 and 4, the portion that the second portion 52 overlap with the first portion 51 and the portion that the second portion 52 overlap with the third portion 53 are away from the substrate 1.

It should be noted that the order of forming the first portion 51, the second portion 52 and the third portion 53 of the connecting trace 5 is not limited here, and FIGS. 3 and 4 are only one example.

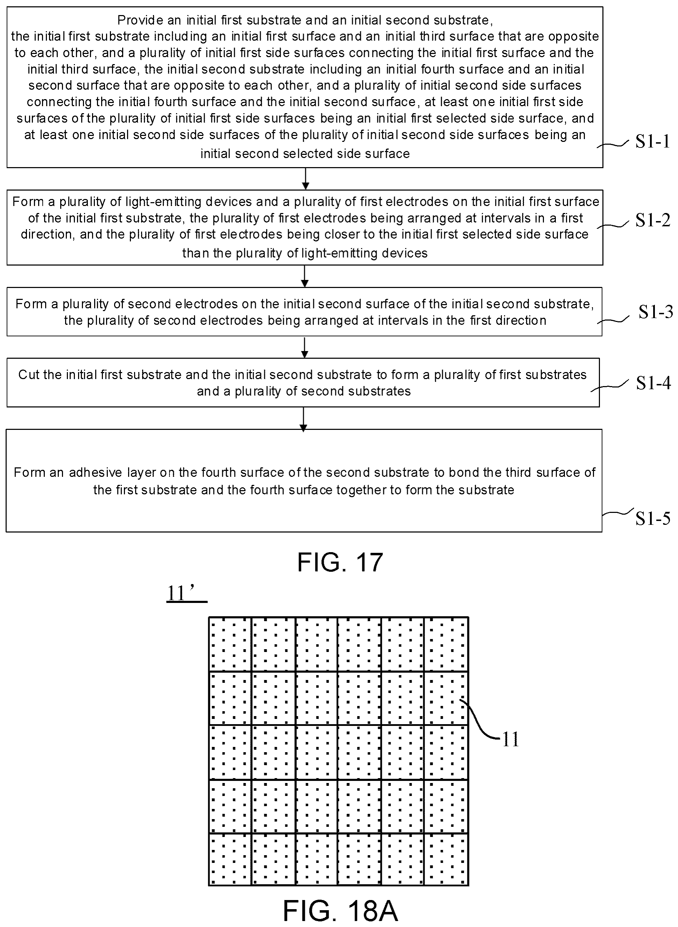

In some embodiments, as shown in FIG. 17, the above-mentioned step S1 of providing the substrate 1 includes the following steps.

In S1-1, an initial first substrate 11' and an initial second substrate 12' are provided.

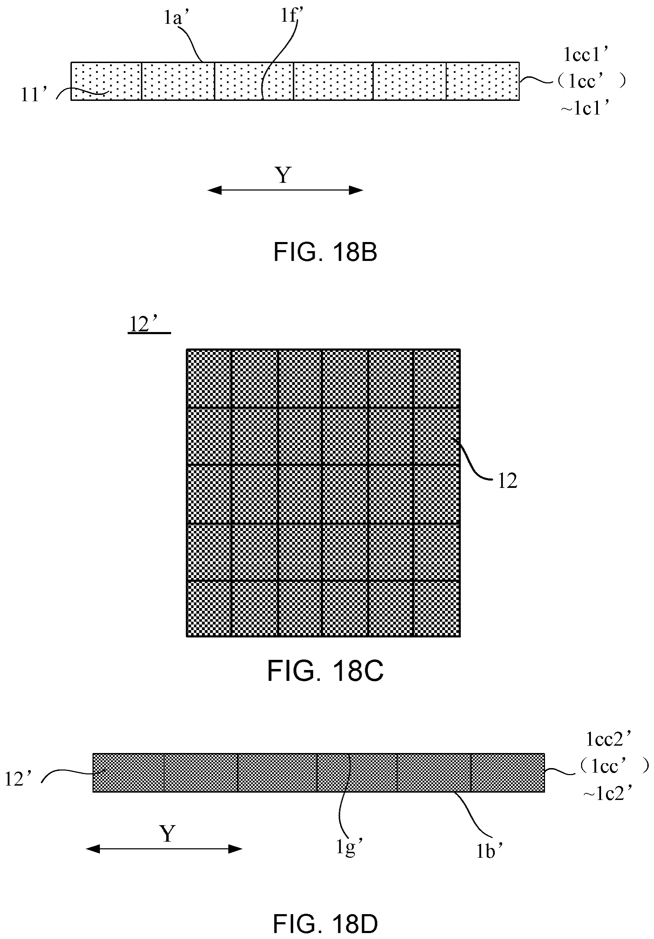

Referring to FIGS. 18A, 18B, 18C and 18D, the initial first substrate 11' includes: an initial first surface 1a' and an initial third surface 1f' that are opposite to each other, and a plurality of initial first side surfaces 1c1' connecting the initial first surface 1a' and the initial third surface 1f'; the initial second substrate 12' includes: an initial fourth surface 1g' and an initial second surface 1b' that are opposite to each other, and a plurality of initial second side surfaces 1c2' connecting the initial fourth surface 1g' and the initial second surface 1b'; at least one initial first side surfaces 1c1' of the plurality of initial first side surfaces 1c1' is an initial first selected side surface 1cc1', and at least one initial second side surfaces 1c2' of the plurality of initial second side surfaces 1c2' is an initial second selected side surface 1cc2'.

Exemplarily, the initial first substrate 11' has four initial first side surfaces 1c1', and one initial first side surface 1c1' or two initial first side surfaces 1c1' of the four initial first side surfaces 1c1' serve as the initial first selected side surface 1cc1'; the initial second substrate 12' has four initial second side surfaces 1c2', and one initial second side surface 1c2' or two initial second side surface 1c2' of the four initial second side surfaces 1c2' serve as an initial first selected side surface 1cc2'.

In S1-2, referring to FIGS. 18A and 18B and FIG. 1, a plurality of light-emitting devices 2 and a plurality of first electrodes 3 are formed on the initial first surface 1a' of the initial first substrate 11', the plurality of first electrodes 3 are arranged at intervals in the first direction X, and the plurality of first electrodes 3 are closer to the initial first selected side surface 1cc1' than the plurality of light-emitting devices 2.

Exemplarily, the plurality of light-emitting devices 2 are located in the display area AA of the initial first surface 1a', and the plurality of first electrodes 3 are located in the peripheral area BB of the initial first surface 1a'.

In S1-3, referring to FIGS. 18C and 18D and FIG. 3, a plurality of second electrodes 4 are formed on the initial second surface 1b' of the initial second substrate 12', and the plurality of second electrodes 4 are arranged at intervals in the first direction X.

Exemplarily, referring to FIGS. 18C and 18D and FIG. 2A, the plurality of second electrodes 4 are disposed on a side of the initial second surface 1b' of the initial second substrate 12' proximate to the initial second selected side surface 1cc2', a dimension D2 of the plurality of second electrodes 4 in the second direction Y is greater than a dimension D1 of the plurality of first electrodes in the second direction Y, that is to say, an orthographic projection of the plurality of second electrodes 4 on the initial first surface 1a' may extend to the display area AA.

It should be noted that the order of forming the plurality of light-emitting devices 2 and the plurality of first electrodes 3 and forming the plurality of second electrodes 4 is not limited in the above description.

In S1-4, with reference to FIGS. 18A to 18D and FIGS. 10A and 10B, the initial first substrate 11' and the initial second substrate 12' are cut to form a plurality of first substrates 11 and a plurality of second substrates 12.

Referring to FIGS. 18A to 18D and FIGS. 10A and 10B, the first substrate 11 includes: a first surface 1a and a third surface 1f that are opposite to each other, and a plurality of first side surfaces 1c1 connecting the first surface 1a and the third surface 1f; the second substrate 12 includes: a fourth surface 1g and a second surface 1b that are opposite to each other, and a plurality of second side surfaces 1c2 connecting the fourth surface 1g and the second surface 1b; the third surface 1f and the fourth surface 1g are close to each other. At least one first side surface 1c1 of the plurality of first side surfaces 1c1 is a first selected side surface 1cc1, and at least one second side surface 1c2 of the plurality of second side surfaces 1c2 is a second selected side surface 1cc2, and the first selected side surface 1cc1 and the second selected side surface 1cc2 are located in the same plane to constitute a selected side surface 1cc of the substrate 1. The first surface 1a' of the initial first substrate 11' includes the first surface of the first substrate 11, and the second surface 1b' of the initial second substrate 12' includes the second surface 1b of the second substrate 12, the first selected side surface 1cc1' of the initial first substrate 11' includes the first selected side surface 1cc1 of the first substrate 11, and the second selected side surface 1cc1' of the initial second substrate 12' includes the second selected side surface 1cc2 of the second substrate 12.

In S1-5, referring to FIGS. 12A and 12B, an adhesive layer 13 is formed on the fourth surface 1g of the second substrate 12 to bond the third surface 1f of the first substrate 11 and the fourth surface 1g together to form the substrate 1.

It will be understood that the substrate 1 includes the first substrate 11 and the second substrate 12, the first substrate 11 and the second substrate 12 are arranged oppositely, the first surface 1a of the first substrate 11 is the first surface 1a of the substrate 1, the second surface 1b of the second substrate 12 is the second surface 1b of the substrate 1, and the third surface 1f of the first substrate 11 and the fourth surface 1g of the second substrate 12 are close to each other. The substrate 1 includes a selected side surface 1cc consists of the first selected side surface 1cc1 and the second selected side surface 1cc2, and the first selected side surface 1cc1 and the second selected side surface 1cc2 are located in the same plane.

It should be noted that during the process of bonding the third surface 1f and the fourth surface 1g together, the edge positions of the first substrate 11 and the second substrate 12 may be misaligned and at which the adhesive layer 13 may overflow or shrink, causing disconnection, short-circuiting and falling off during the subsequent process of fabricating the connecting traces. In order to avoid the above phenomenon, after the bonding process of the third surface 1f and the fourth surface 1g is completed, the first selected side surface 1cc1 of the first substrate 11 and the second selected side surface 1cc2 of the second substrate 12 are ground, so that the first selected side surface 1cc1 and the second selected side surface 1cc2 are allowed to located in the same plane, so as to ensure the alignment and evenness of the first selected side surface 1cc1 and the second selected side surface 1cc2.

The order of the above steps S1-4 and S1-5 is not limited in the process of manufacturing the substrate. For convenience of description, the device structures on the substrate are omitted in the following flow charts.

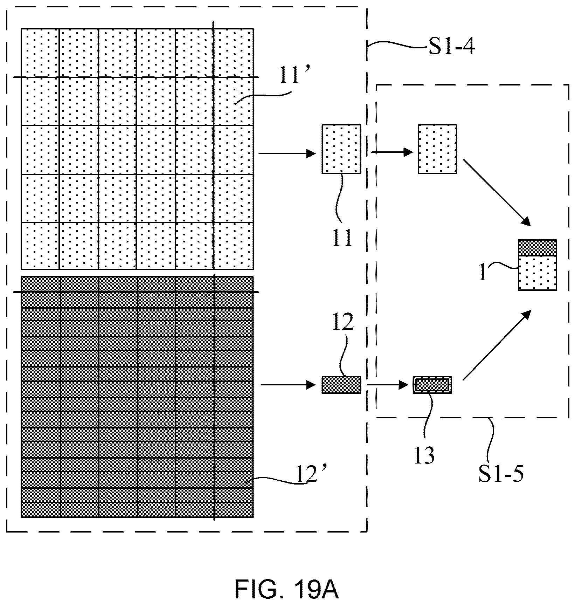

In some embodiments, step S1-4 is performed before step S1-5. As shown in FIG. 19A, FIG. 19A is a flow chart of forming a substrate. Referring to FIG. 19A, firstly, an initial first substrate 11' and an initial second substrate 12' are provided, and the initial first substrate 11' and the initial second substrate 12' are cut (the dotted line in the figure is the cutting line) to obtain first substrates 11 and second substrates 12; then, an adhesive layer 13 is formed on the fourth surface 1g of the second substrate 12 to bond the third surface 1f of the first substrate 11 to the fourth surface 1g together to form the substrate 1.

The sizes of the first substrate 11 and the second substrate 12 shown in FIG. 19A are only one example, and detailed description may be referred to the description in the foregoing part.

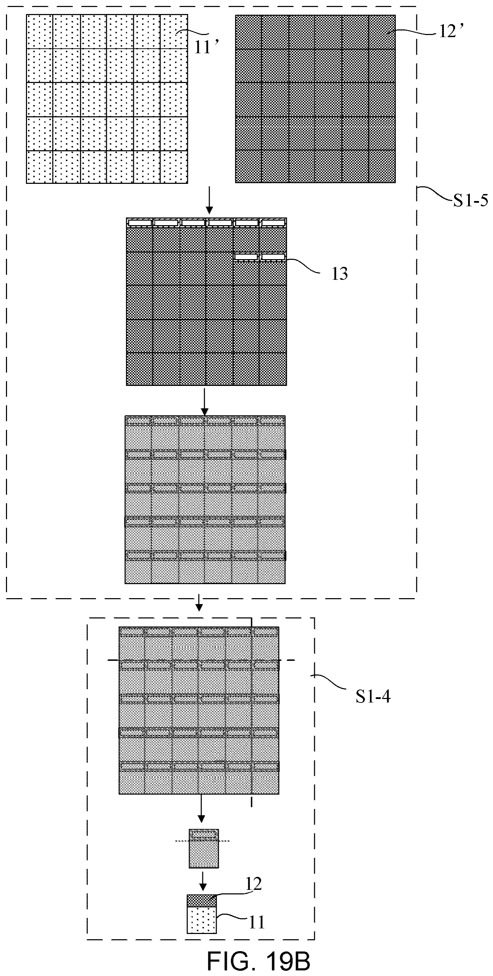

In some embodiments, step S1-5 is performed before step S1-4. As shown in FIG. 19B, FIG. 19B is a flow chart of forming a substrate. Referring to FIG. 19B, firstly, an initial first substrate 11' and an initial second substrate 12' are provided, and the initial second substrate 12' is divided into a plurality of second substrate areas; secondly, an adhesive layer 13 is formed on the fourth surface 1g' of the initial second substrate 12', the adhesive layer 13 is disposed at a position proximate to a side edge of each second substrate area to bond the third surface 1f' of the initial first substrate 11' to the fourth surface 1g' of the initial second substrate 12'; and then, the bonded initial substrate is cut twice (the dotted line in the figure is the cutting line) to obtain the substrate 1. The second cutting is to remove the portion of the second substrate that is not attached with the adhesive layer.

The first region and the second region of the second surface of the substrate 1 formed above are respectively at the different distances from the first surface.

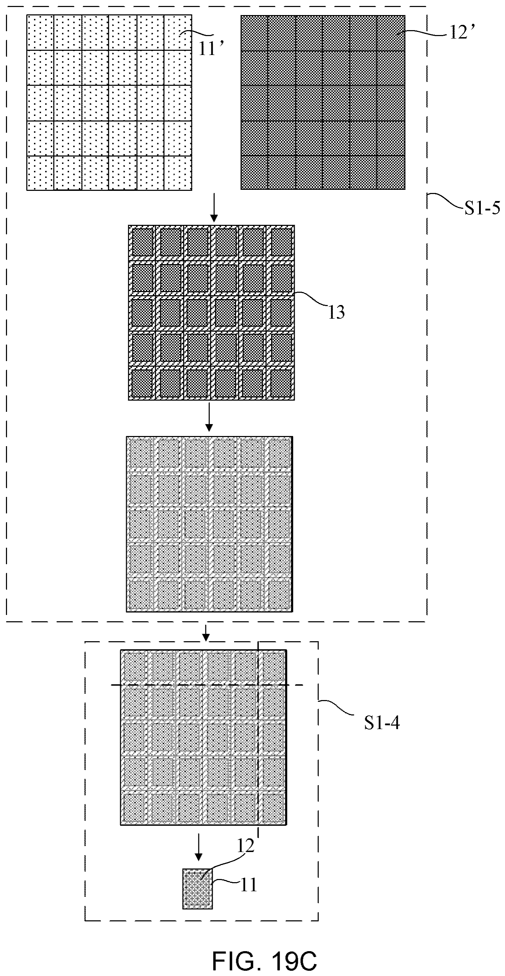

In some embodiments, step S1-5 is performed before S1-4. As shown in FIG. 19C, FIG. 19C is a flow chart of forming a substrate. Referring to FIG. 19C, firstly, an initial first substrate 11' is and an initial second substrate 12' are provided, the initial second substrate 12' is divided into a plurality of second substrate areas; secondly, an adhesive layer 13 is formed on the fourth surface 1g' of the initial second substrate 12', the adhesive layer 13 is disposed at the edge of each second substrate area, the third surface 1f of the initial first substrate 11' is bonded to the fourth surface 1g' of the initial second substrate 12', and the bonded initial substrate is cut once (the dotted line in the figure is the cutting line) to obtain the substrate 1.

The first region and the second region of the second surface of the substrate 1 formed above are respectively at the same distance from the first surface.

Considering the first region and the second region of the second surface of the substrate are at different distances from the first surface as an example, a manufacturing method for forming connecting traces will be described below.

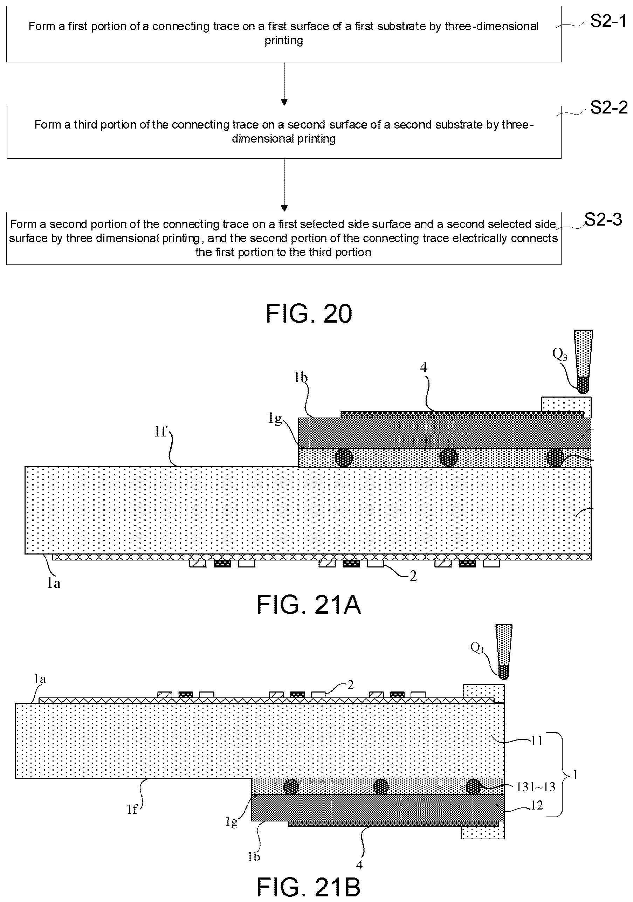

In some embodiments, referring to FIG. 20, the above step S2 of forming the plurality of connecting traces 5 on the first surface 1a, the selected side surface 1cc and the second surface 1b includes the following steps.

In S2-1, referring to FIG. 21B, the first portion 51 of the connecting trace 5 is formed on the first surface 1a of the first substrate 11 by three-dimensional printing.

It should be noted that a part of the first portion 51 is located on the first surface 1a of the substrate 1 and another part of the first portion 51 is located on the first transition side surface 1d between the first surface 1a and the selected side surface 1cc. Therefore, in the process of forming the first portion 51 of the connecting trace, there is a need to ensure that the conductive paste is discharged at a predetermined starting position Q₁, and the starting position Q₁ of the three-dimensional printing device is located on a side of the selected side surface 1cc away from the first surface 1a of the substrate 1.

In S2-2, referring to FIG. 21A, the third portion 53 of the connecting trace 5 is formed on the second surface 1b of the second substrate 12 by three-dimensional printing.

Exemplarily, in the process of forming the third portion 53 of the connecting trace, the starting position Q₃ of the three-dimensional printing device is above the interface of the selected side surface 1cc and the second surface 1b. The specific principle may be referred to the description of forming the first portion 51, which will not be repeated here.

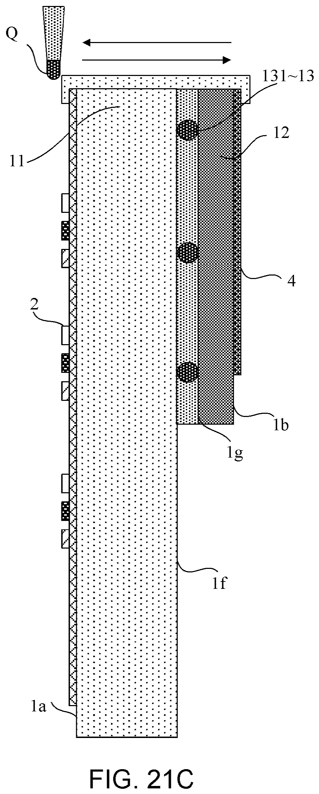

In S2-3, referring to FIG. 21C, the second portion 52 of the connecting trace 5 is formed on the first selected side surface 1cc1 and the second selected side surface 1cc2 by three-dimensional printing. The second portion 52 of the connecting trace 5 electrically connects the first portion 51 to the third portion 53.

Exemplarily, the starting position Q of the three-dimensional printing device is on a side of the selected side surface 1cc away from the substrate 1 and close to an end of the first surface 1a of the substrate 1, the printing direction is a direction from the first portion to the third portion, the device is turned off in advance when close to the end position, and two ends of the second portion are ensured to respectively lap the first portion and the third portion. Alternatively, the printing direction is a direction from the third portion to the first portion. The printing direction is illustrated by the arrows with two directions as shown in FIG. 21C, and there is no limit to the printing direction here.

It should be noted that the order of the above-mentioned step S2-1 and step S2-2 is not limited. Referring to the process diagrams shown in FIGS. 21A to 21C, which is an example of performing step S2-2 first and then performing step S2-1, and in the flow chart corresponding to the above-mentioned step S2, FIGS. 21A to 21C are illustrated by taking an example in which the distance between the first surface and the first region of the second surface of the substrate is different from the distance between the first surface and the second region of the second surface of the substrate.

Alternatively, the step S2 of forming the plurality of connecting traces 5 on the first surface 1a, the selected side surface 1cc and the second surface 1b specifically is as follows.

In S21, a material of the connecting trace 5 is provided on the selected side surface 1cc by three-dimensional printing, and the material of the connecting trace 5 is provided on the first surface 1a and the second surface 1b to lap both the first electrode 3 and the second electrode 4 to form the plurality of connecting traces 5.

Exemplarily, the material forming the connecting trace 5 is, for example, silver paste, which has fluidity. When forming the second portion 52 of the connecting trace, the silver paste may extend to the first surface 1a and the second surface 1b, achieving flowing overlapping with both the first electrode 3 and the second electrode 4 to form the plurality of connecting traces 5.

It should be noted that the above-mentioned process of forming the plurality of connecting traces may also be a pad printing process or a screen printing process, and there is no limit here. The connecting traces obtained by using the above manufacturing process may avoid damage and corrosion, and may also avoid laser etching from causing certain damage to the film layer on the front of the display panel 10, thereby simplifying the manufacturing process of the display panel and improving the yield of display panel in the manufacturing process.

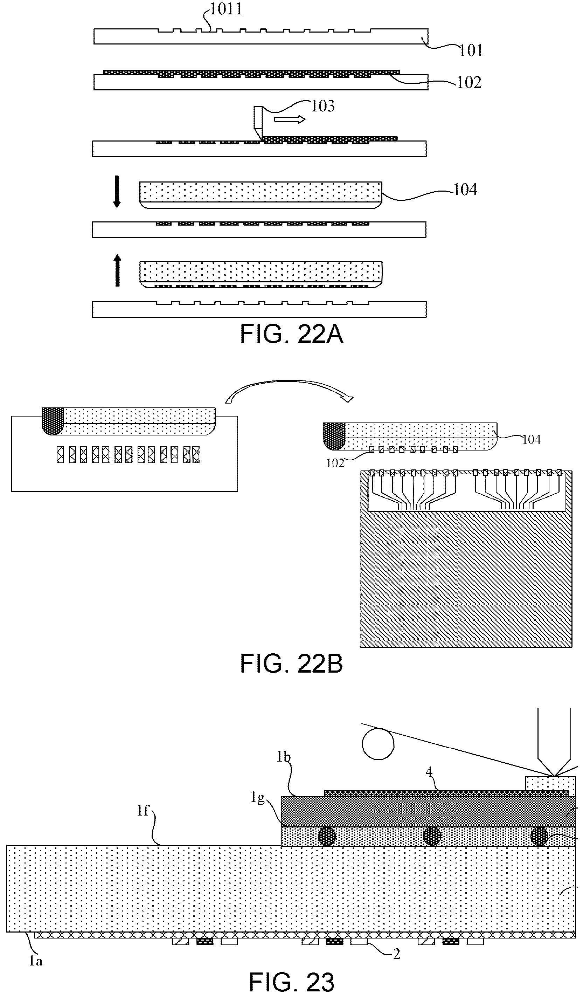

In some embodiments, referring to FIGS. 22A and 22B, the above step S2 of forming the plurality of connecting traces 5 on the first surface 1a, the selected side surface 1cc and the second surface 1b includes:

S2-1, forming the first portion 51 of the connecting trace 5 on the first surface 1a of the first substrate 11 by pad printing;

S2-2, forming the third portion 53 of the connecting trace 5 on the second surface 1b of the second substrate 12 by pad printing; and

S2-3, forming the second portion 52 of the connecting trace 5 on the first selected side surface 1cc1 and the second selected side surface 1cc2 by pad printing, the second portion 52 of the connecting trace 5 electrically connecting the first portion 51 to the third portion 53.

Exemplarily, the pad printing head used in the pad printing process is made of silicone, and the conductive paste that can be transferred to the pad printing head is silver paste; the silver paste is composed of silver particles and resin solvents.

It should be noted that, the order of the step S2-1 and step S2-2 is not limited. Specifically, referring to the diagram showing the pad printing process shown in FIG. 22A, the conductive paste 102 is evenly applied on the steel mesh 101 provided therein with the trace pattern 1011, and a scraper 103 is used to remove and smooth the excess conductive paste on the surface of the steel mesh with the trace pattern, the pad printing head 104 is pressed down to dip the conductive paste 102 in the trace pattern 1011, and the conductive paste is transferred to the pad printing head 104 as the pad printing head ascends; when the position to be printed on the substrate is adjusted to correspond to the position of the conductive paste on the pad printing head 104, referring to FIG. 22B, the pad printing head is pressed down to print the conductive paste at the position to be printed on the substrate, thereby forming the side connecting traces. Referring to the above introduction, in the process of forming the connecting traces, three pad printing processes are required, that is, there is a need to pad print three times.

In some cases, referring to FIG. 22B and FIG. 4, in the process of forming the connecting trace 5 by using the above pad printing process, the maximum width B1 of the first portion 51 of the formed connecting trace 5 in the first direction X and/or the maximum width B3 of the third portion 53 of the formed connecting trace 5 in the first direction X is greater than the maximum width B2 of the second portion 52 of the formed connecting trace 5 in the first direction X. For example, in the process of forming the first portion 51 of the connecting trace 5, the length of the first portion 51 is less than the length of the second portion 52, and the first portion 51 is located on the first surface 1a and the first transition side surface 1d. In order to ensure that the first portion 51 is formed by pressing the pad printing head 104 once, there is a need to apply a relatively large force to the pad printing head 104, so that the conductive paste may be provided on the first transition side surface 1d while the conductive paste is provided on the first surface 1a. Thus, the larger the force applied to the pad printing head 104, the larger the deformation of the pad printing head 104, and the larger the contact area between the pad printing head 104 and the substrate, so that the maximum width B1 of the formed first portion 51 in the first direction X is greater than the maximum width B2 of the second portion 52 in the first direction X. The process of forming the third portion 53 of the connecting traces may also be referred to the process of forming the first portion 51.

In some cases, as shown in FIG. 22B and FIG. 4, the surface of the pad printing head is an arc surface. In the process of forming the second portion 52 of the connecting trace 5, due to the relatively great length of the second portion 52, the starting end of the conductive paste dipped by the pad printing head is first in contact with an end of the selected side surface 1cc of the substrate proximate to the first surface 1a, and the pad printing of the starting end of the second portion 52 is complete, then the pad printing head is rotated to make other positions of the conductive paste to be sequentially in contact with the selected side surface, forming the middle part and tail end of the second portion. When forming the starting end of the second portion 52, the force applied to the pad printing head is larger than the middle portion and the tail end, resulting in that the dimension d5 of the first end 52a of the connecting trace 5 in the first direction X is greater than the dimension d6 of the second end 52b in the first direction. The second portion 52 includes a first end 52a and a second end 52b. The first end 52a is the starting end and the second end is the tail end.

In some embodiments, the process of forming the connecting traces adopts a screen printing process. Referring to FIG. 23, only the third portion of the connecting trace that is formed by screen printing process is taken as an example here. In a case where the screen printing process is adopted, the connecting trace is formed by performing the screen printing process three times, which respectively are first forming the first portion on the front of the substrate and the third portion on the back of the substrate, and then forming the second portion on the side surface.

In some cases, all portion of the connecting trace formed by the screen printing process also has the above-mentioned dimension relationship, which may be achieved by controlling the filling amount and flow rate of the conductive paste during the screen printing process, which will not be described in detail here.

The above are only specific embodiments of the present disclosure, but the protection scope of the present disclosure is not limited thereto, and variations or substitutions that any person skilled in the art may conceive of within the technical scope of the present disclosure shall fall within the protection scope of the present disclosure. Therefore, the protection scope of the present disclosure should be determined by the protection scope of the claims.

## Claims

1. A display panel, comprising:
a substrate including a first surface, a second surface and a plurality of side surfaces connecting the first surface and the second surface, wherein at least one of the plurality of side surfaces is a selected side surface;
a plurality of light-emitting devices disposed on the first surface;
a plurality of first electrodes disposed on the first surface and arranged at intervals in a first direction, wherein the plurality of first electrodes are closer to the selected side surface than the plurality of light-emitting devices;
a plurality of second electrodes disposed on the second surface, wherein the plurality of second electrodes are arranged at intervals in the first direction and close to the selected side surface; and
a plurality of connecting traces arranged in parallel and at intervals, wherein each connecting trace of the plurality of connecting traces includes a first portion, a second portion and a third portion that are connected in sequence; the first portion is disposed at least on the first surface, and the first portion is electrically connected to a first electrode of the plurality of first electrodes; the second portion is disposed on the selected side surface; the third portion is disposed at least on the second surface and electrically connected to a second electrode of the plurality of second electrodes;
wherein a maximum width of the first portion in the first direction and/or a maximum width of the third portion in the first direction is greater than a maximum width of the second portion in the first direction.

2. The display panel according to claim 1, wherein for at least one connecting trace,
in at least two line segments, in the first direction, of an orthographic projection pattern of a first portion on the first surface, a dimension of a line segment proximate to the selected side surface in the first direction is greater than a dimension of another line segment away from the selected side surface in the first direction; and/or
in at least two line segments, in the first direction, of an orthographic projection pattern of a third portion on the second surface, a dimension of a line segment proximate to the selected side surface in the first direction is greater than a dimension of another line segment away from the selected side surface in the first direction.

3. The display panel according to claim 2, wherein the second portion of the connecting trace includes a first end and a second end, a dimension of the first end in the first direction is greater than a dimension of the second end in the first direction, and the first end and the second end are two opposite ends of the second portion of the connecting trace in an extension direction of the second portion.

4. The display panel according to claim 2 or 3, wherein the first portion partially overlaps with the first electrode, and the third portion partially overlaps with the second electrode.

5. The display panel according to any one of claims 1 to 4, further comprising a plurality of signal lines disposed on the first surface, wherein the plurality of signal lines electrically connect the plurality of first electrodes and the plurality of light-emitting devices, each signal line is electrically connected to a first electrode, and a dimension of the signal line in the first direction is not greater than a dimension of the first electrode in the first direction.

6. The display panel according to claim 5, wherein the display panel further comprises at least one extension line disposed on a side of at least one first electrode proximate to the selected side surface;
wherein the at least one extension line is electrically connected to a first electrode, and the at least one extension line is electrically connected to a connecting trace.

7. The display panel according to claim 6, wherein a number of extension lines electrically connected to the first electrode is multiple, and a spacing between any two extension lines is greater than or equal to 60 µm.

8. The display panel according to claim 7, wherein at least two extension lines are electrically connected to a first portion of the connecting trace; wherein
a dimension of the first portion in the first direction is greater than a spacing between two extension lines; or
the first portion includes at least two sub-portions, a dimension of any sub-portion in the first direction is not less than a dimension of any extension line in the first direction, and the at least two sub-portions respectively overlap with the at least two extension lines.

9. The display panel according to claim 8, wherein a dimension of an extension line in the first direction is less than or equal to 30 µm.

10. The display panel according to any one of claims 6 to 9, wherein the plurality of signal lines and the extension line are formed by a first metal layer, the plurality of first electrodes are formed by the first metal layer and a second metal layer, wherein the second metal layer is further away from the first surface than the first metal layer.

11. The display panel according to claim 10, wherein for a signal line and an extension line that are connected to each other, a dimension of the signal line in the first direction is greater than a dimension of the extension line in the first direction.

12. The display panel according to claims 1 to 11, wherein the substrate includes a first substrate and a second substrate; the first substrate includes: the first surface and a third surface that are opposite to each other, and a plurality of first side surfaces connecting the first surface and the second surface; the second substrate includes: a fourth surface and the second surface that are opposite to each other, and a plurality of second side surfaces connecting the fourth surface and the second surface; the third surface and the fourth surface are close to each other; at least one first side surface of the plurality of first side surfaces is a first selected side surface, at least one second side surface of the plurality of second side surfaces is a second selected side surface, and the first selected side surface and the second selected side surface are located in a same plane to constitute the selected side surface of the substrate.

13. The display panel according to claim 12, wherein the second surface includes a first region and a second region, the first region and the first surface have a first distance therebetween, and the second region and the first surface have a second distance therebetween, and the first distance is greater than the second distance.

14. The display panel according to claim 13, wherein the first distance is twice the second distance.

15. The display panel according to any one of claims 12 to 14, wherein the substrate further includes an adhesive layer; the adhesive layer is disposed between the third surface and the fourth surface and configured to bond the third surface and the fourth surface together.

16. The display panel according to claim 15, wherein a material of the adhesive layer is a thermal curing or ultraviolet (UV) curing material, and a plurality of silicone balls are evenly provided in the adhesive layer.

17. A display apparatus, comprising:
the display panel according to any one of claims 1 to 16; and
a driving circuit board, wherein the driving circuit board is disposed on the second surface of the substrate of the display panel and electrically connected to the plurality of connecting traces of the display panel.

18. A tiled display apparatus, comprising a plurality of the display apparatuses according to claim 17, wherein selected side surfaces of display apparatuses located in a same row or a same column are located on a same side.
